(19) Europäisches Patentamt
European Patent Office
Office européen des brevets

(11) EP 1 269 526 B1

(12) **EUROPEAN PATENT SPECIFICATION**

(45) Date of publication and mention of the grant of the patent:
**19.08.2009 Bulletin 2009/34**

(21) Application number: **01923913.6**

(22) Date of filing: **05.04.2001**

(51) Int Cl.:
***H01L 21/205** (2006.01)* ***B81B 3/00** (2006.01)*

(86) International application number:
**PCT/IB2001/000765**

(87) International publication number:
**WO 2001/074708 (11.10.2001 Gazette 2001/41)**

# (54) METHOD FOR DEPOSITING POLYCRYSTALLINE SIGE SUITABLE FOR MICROMACHINING

VERFAHREN ZUM ABSCHEIDEN EINES ZUR MIKROBEARBEITUNG GEEIGNETEN POLYKRISTALLINEN SIGE

PROCEDE DE DEPOT DE SiGe POLYCRISTALLIN ADAPTE AU MICRO-USINAGE

(84) Designated Contracting States:
**AT BE CH CY DE DK ES FI FR GB GR IE IT LI LU MC NL PT SE TR**

(30) Priority: **05.04.2000 US 194836 P**
**17.04.2000 US 197881 P**

(43) Date of publication of application:
**02.01.2003 Bulletin 2003/01**

(73) Proprietor: **IMEC**
**3001 Leuven (BE)**

(72) Inventors:
- **SEDKY, Sherif**
  **Gize (EG)**
- **WITVROUW, Ann**
  **B-3020 Herent (BE)**
- **BAERT, Kris**
  **B-3001 Leuven (BE)**
- **CAYMAX, Matty**
  **B-3001 Leuven (BE)**
- **RUSU, Cristina**
  **B-3001 Heverlee (BE)**

(74) Representative: **Van Malderen, Joëlle et al**
**pronovem - Office Van Malderen**
**Avenue Josse Goffin 158**
**1082 Bruxelles (BE)**

(56) References cited:
**EP-A- 0 867 701** **FR-A- 2 765 245**
**US-A- 5 241 193**

- **TSU-JAE KING ET AL: "DEPOSITION AND PROPERTIES OF LOW-PRESSURE CHEMICAL-VAPOR DEPOSITED POLYCRYSTALLINE SILICON-GERMANIUM FILMS" JOURNAL OF THE ELECTROCHEMICAL SOCIETY, ELECTROCHEMICAL SOCIETY. MANCHESTER, NEW HAMPSHIRE, US, vol. 141, no. 8, 1 August 1994 (1994-08-01), pages 2235-2241, XP000471081 ISSN: 0013-4651**
- **FRANKE A E ET AL: "POST-CMOS INTEGRATION OF GERMANIUM MICROSTRUCTURES" TECHNICAL DIGEST OF THE IEEE INTERNATIONAL MEMS '99 CONFERENCE. 12TH IEEE INTERNATIONAL CONFERENCE ON MICRO ELECTRO MECHANICAL SYSTEMS. ORLANDO, FL, JAN. 17 - 21, 1999, IEEE INTERNATIONAL MICRO ELECTRO MECHANICAL SYSTEMS CONFERENCE, NEW YORK, NY: IEE, 1999, pages 630-637, XP000830820 ISBN: 0-7803-5195-9**
- **UNEWISSE M H ET AL: "THE GROWTH AND PROPERTIES OF SEMICONDUCTOR BOLOMETERS FOR INFRARED DETECTION" PROCEEDINGS OF THE SPIE, SPIE, BELLINGHAM, VA, US, vol. 2554, 13 July 1995 (1995-07-13), pages 43-54, XP002039425**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 269 526 B1

## Description

### Field of the invention

The invention is related to methods to obtain as-deposited polycrystalline and low-stress SiGe layers. These layers are used in Micro Electro-Mechanical Systems (MEMS) devices or micromachined structures.

### Background of the invention

MicroElectroMechanical Systems (MEMS) are used in a wide variety of systems such as accelerometers, gyroscopes, infrared detectors, micro turbines, etc. For high volume applications, fabrication costs can possibly be reduced by monolithic integration of MEMS with the driving electronics. Also, for 2D imaging applications (e.g., detectors, displays) monolithic integration of MEMS and CMOS is a good solution as this simplifies the interconnection issues. The easiest approach for monolithic integration is post-processing MEMS on top of the driving electronics, as this does not introduce any change into standard fabrication processes used for realising the driving electronics. It also allows the realisation of a more compact micro-system as the MEMS device can be formed on top of the driving electronics. This is not possible if the MEMS-device is produced prior to the formation of the driving electronics. On the other hand, post processing imposes an upper limit on the fabrication temperature of MEMS to avoid any damage or degradation in the performance of the driving electronics. An overview of the several approaches with respect to hybrid integration of driving electronics and MEMS devices can be found in 'Why CMOS-integrated transducers? A review', Microsystem Technologies, Vol. 6 (5), p 192-199, 2000, by A. Witvrouw et al.

For many micromachined devices, such as transducers and other free-standing structures, the mechanical properties of the applied thin films can be critical to their success. For example, stress or stress gradients can cause free-standing thin-film structures to warp to the point that these structures become useless. In particular, in MEMS processing, a sacrificial layer is first deposited on the substrate, as disclosed in U.S. Patent No. 6,194,722, entitled "Method of Fabrication of An Infrared Radiation Detector and Infared Detector Device." U.S. Patent No. 6,194,722 is hereby incorporated by reference in its entirety. A second layer is then formed on the sacrificial layer. Thereafter, at least a portion (and preferably all of) the sacrificial layer is removed. The second layer is thereafter subject to bending and warping due to stresses in the second layer.

The control of stress of polycrystalline silicon (poly Si) has been widely used for MEMS applications. The main disadvantage of this material is that it requires high processing temperature, higher than 800°C, to achieve the desired physical properties especially stress as explained in "Strain studies in LPCVD polysilicon for surface micromachined devices," Sensors and Actuators A (physical), A77 (2), p. 133-8 (1999), by J. Singh S. Chandra et al.

Polycrystalline silicon germanium (poly SiGe) seems to be an attractive alternative to poly Si as it has similar properties. The use of polycrystalline silicon germanium as a low bandgap material for electronic applications such as gate-electrode, multi-junction solar cells or thin film transistors (TFT) as used e.g. in large area electronics such as active matrix liquid crystal displays, is known in the art. For these applications the defect density, the conductivity and the crystal structure of the poly SiGe layer are of importance. The corresponding deposition methods aim at the control of the grain boundaries and might include steps to recrystallize the as-deposited layer. The presence of germanium reduces the melting point of the silicon germanium alloy and hence the desired physical properties are expected to be realised at lower temperatures, allowing the growth on low-cost substrates such as glass. Depending on the germanium concentration and the deposition pressure, the transition temperature from amorphous to polycrystalline can be reduced to 450°C, or even lower, compared to 580°C for LPCVD poly Si.

In EP application EP 0 867 702, a method for fabrication an infrared detector device is disclosed. An infrared detector is an example of a MEMS device. As poly SiGe has a 5 times lower thermal conductivity compared to poly Si, the applicant used poly SiGe in the formation of the infrared detector. The applicant outlined the necessity to use thin films with a low, preferably tensile, internal stress. The application therefore discloses a method of controlling the stress in a polycrystalline SiGe layer deposited on a substrate such as silicon oxide, by varying the deposition pressure and/or the annealing temperature. In a preferred embodiment of the application, an RPCVD (reduced pressure chemical vapour deposition) deposition process for forming poly SiGe is disclosed. PCT application WO 00/42231 discloses the use of silicon-germanium as a sacrificial and as a structural layer to create free-standing or overhanging MEMS structures. The poly SiGe was deposited in a LPCVD system at 600 mTorr, resulting in a low compressive stress as explained in "Post CMOS Modular Integration of poly-SiGe microstructures using poly-Ge sacrificial layers," Solid state sensors and actuator workshop June 4-8 2000 by A.E. Franke et al.

The following documents also concern the control of stress in the deposition of SiGe layers:

FR-A-2 765 245;

TSU-JAE KING ET AL: "DEPOSITION AND PROPERTIES OF LOW-PRESSURE CHEMICAL-VAPOR DEPOSITED POLYCRYSTALLINE SILICON-GERMANIUM FILMS" JOURNAL OF THE ELECTROCHEMICAL SOCIETY, ELECTROCHEMICAL SOCIETY. MANCHESTER, NEW HAMPSHIRE, US, vol. 141, no. 8, 1 August 1994 (1994-08-01), pages 2235-2241;

FRANKE A E ET AL: "POST-CMOS INTEGRATION OF GERMANIUM MICROSTRUCTURES" TECHNICAL DIGEST OF THE IEEE INTERNATIONAL MEMS '99 CONFERENCE. 12TH IEEE INTERNATIONAL CONFERENCE ON MICRO ELECTRO MECHANICAL SYSTEMS. ORLANDO, FL, JAN. 17-21, 1999, IEEE INTERNATIONAL MICRO ELECTRO MECHANICAL SYSTEMS CONFERENCE, NEW YORK, NY: IEE, 1999, pages 630-637; and

UNEWISSE M H ET AL: "THE GROWTH AND PROPERTIES OF SEMICONDUCTOR BOLOMETERS FOR INFRARED DETECTION" PROCEEDINGS OF THE SPIE, SPIE, BELLINGHAM, VA, US, vol. 2554, 13 July 1995 (1995-07-13), pages 43-54.

**Summary of the invention**

The present invention has as an object the development of in-situ doped low-stress polycrystalline-SiGe layers under different deposition conditions.

The invention is defined in the appended claims.

Different parameters are analysed to determine their effect on stress in a polycrystalline layer. The parameters include, without limitation: deposition temperature; concentration of semiconductors (*e.g.*, the concentration of Silicon and Germanium in a $Si_xGe_{1-x}$ layer, with x being the concentration parameter); concentration of dopants (*e.g.*, the concentration of Boron or Phosphorous); amount of pressure; and use of plasma. Depending on the particular environment in which the polycrystalline SiGe is grown, different parameters are used.

In a first aspect of the invention, the effect of the deposition temperature and the concentration of the semiconductors are analysed. When the SiGe layer is deposited undoped, the effect of decreasing the deposition temperature of poly SiGe and the germanium/silicon concentration is analysed. In an example examining structural and mechanical properties of the grown films using an RPCVD SiGe deposition process, the deposition temperature is decreased from 650 Celsius, preferably to a range of 500 Celsius to 550 Celsius, and more preferably to approximately 500 Celsius. This decrease in temperature decreases the stress in the SiGe structural layer in the MEMS device. Moreover, the concentration of the germanium in the SiGe layer is modified to likewise decrease the stress in the SiGe layer. As one example, the Ge concentration is set to a range of 30% (i.e., $Si_{70}Ge_{30}$) to 100% (*i.e.,* $Si_0Ge_{100}$, or Ge). In still a preferred example the Ge concentration range is set to be greater than 40%.

In a further example the SiGe layer is deposited undoped and doping is done afterwards, parameters for the doping (such as doping concentrations and annealing temperatures), in addition to deposition temperature and concentration of semiconductors, are analysed. In some applications, doping is unnecessary, so that this parameter need not be factored into the stress of the device. In other applications, the poly SiGe layer needs to be doped. When the doping involves an ion implantation and a subsequent annealing step, the parameters associated with the concentration of the dopant and the temperature of the annealing step are analysed. In one example, the concentration of the dopant boron and the annealing temperature are analysed. The implanted boron in the CVD deposited SiGe layer is performed at a CMOS compatible temperature. The annealing step can accomplish the goal of activating the implanted dopants and also reducing the stress in the SiGe layer. This activation can be done simultaneously with the annealing of the in-situ doped SiGe layers. In a preferred example, this activation is done above 450°C and in still a preferred example, in a range of 450°C to 520°C. The activation temperature depends on the implanted boron dose and the Ge content in the deposited layer. In a preferred embodiment, the boron dose is in the range of $10^{16}$ B/cm$^2$, while the Ge content in the SiGe layer is above 70%, more preferably above 80%. The activation temperature is below 500°C, more preferably below 450°C.

In an aspect of the invention, the effect of the deposition temperature, the concentration of the semiconductors and concentration of dopants are analysed. Specifically, when the SiGe layer is deposited doped, different parameters such as the temperature at which the SiGe layer is deposited, the concentration of Si and Ge in the layer and the concentration of dopants (*e.g.*, Boron or Phosphorous) each effect the stress of the SiGe layer. Different processes may be used to deposit the doped SiGe layer including with (PECVD) or without (CVD) plasma power are disclosed at pressures between 300 mTorr and 2 Torr and wafer temperatures between 400C and 550C.

In this aspect, a CVD process is disclosed. For the in-situ doped CVD layers, deposited at 400°C, it is demonstrated that stress in the as-deposited layers can be tuned at 450C to realise surface micromachined structures suitable for MEMS post processing on top of standard CMOS wafers without introducing any damage in the performance of the driving electronics. Furthermore, the resistivity of the as-grown layers is as low as 1mΩ.cm, and hence it can be used as a seeding layer for polycrystalline Si solar cells compatible with glass substrates. The deposition of in-situ boron doped polycrystalline at lower temperature, in the range of 400 to 500 Celsius, is feasible if the Ge concentration is high enough, preferably above 70% and if the boron concentration is high enough, above $10^{19}/cm^3$. The stress can be further decreased by a subsequent anneal, preferably about 450 Celsius of the as-deposited crystalline film.

In a second embodiment of this aspect a PECVD process is disclosed. The in-situ doped PECVD layers with good as-deposited mechanical were grown both at temperatures compatible with CMOS or at higher temperatures. Good electrical characteristics were also obtained at elevated deposition temperatures. The advantage of the PECVD process is the strongly increased deposition rate compared to the thermal deposition methods, making the layers economically interesting for thick conducting micro-machined membranes. Compared to thermally grown layers as disclosed in the first embodiment of this second aspect, plasma-enhanced deposition gives the possibility of direct deposition on Si-oxide, without the use of a nucleation layer.

The deposition of in-situ doped low stress polycrystalline polySiGe according to this embodiment offers the opportunity of high speed deposited but still low stress polycrystalline layers if for a deposition temperature in the range from 400 to 470 Celsius and a power in the range from 30 to 50W the germanium concentration is high enough, preferably above 70%. If the deposition temperature is above 550 Celsius a low-stress in-situ doped polycrystalline SiGe layer with low resistivity is obtained.

## Brief Description Of The Drawings

All drawings are intended to illustrate some aspects and embodiments of the present invention. Devices and fabrication steps are depicted in a simplified way for reason of clarity. Not all alternatives and options are shown and therefore the invention is not limited to the content of the given drawings. Like numerals are employed to reference like parts in the different figures.

Figure 1 shows a graph of annealing temperature versus sheet resistance, with the determination of the exact wafer temperature T (Celsius) in an Epsilon I CVD reactor. In the figure, diamonds refer to furnace measurements, and squares refer to Epsilon measurements.

Figure 2 shows a graph demonstrating the effect of the reactor temperature T (Celsius) and gas flow rates (0 sccm silane (circles in the figure), 10 sccm silane (stars in the figure) and 20 sccm silane (diamonds in the figure)) on the growth rate v (Ångstrom/minute) of poly SiGe layers or poly Ge layers deposited at 40 Torr. The compositions of the poly $Si_xGe_y$ are, at a reactor temperature of 550C, as follows:

x = 0, y = 1 for a silane flow of 0,
x = 0.57, y = 0.43 for a silane flow of 10 sccm and
x = 0.67, y = 0.33 for a silane flow of 20 sccm.

Figures 3a-3c demonstrates the dependence of crystal structure on deposition temperature T (Celsius) by XRD for various silane flows. Intensity I of XRD is given in arbitrary units (a.u.), with Figure 3a having silane flow = 0 sccm, Figure 3b having silane flow =10 sccm, and Figure 3c having silane flow = 20 sccm

Figure 4 demonstrates the dependence of crystal structure on process pressure p by XRD I (a.u.) for 10sccm silane and a reactor temperature of 550°C.

Figure 5 shows a graph of deposition temperature versus stress, illustrating the dependence of stress σ (MPa) of poly SiGe and poly Ge on deposition temperature T (Celsius) for various silane flows. The compositions of the poly $Si_xGe_y$ are x = 0, y = 1 for a silane flow of 0 sccm (represented by circles), x = 0.57, y = 0.43, for a silane flow of 10 sscm (represented by stars);and x = 0.67, y = 0.33, for a silane flow of 20 sscm (represented by diamonds).

Figures 6a-c shows surface micromachined structures of Poly $Si_{57}Ge_{43}$ deposited at a reactor temperature of 550°C, with Figure 6a showing an Array of 50 μm x 50 μm Pixels, and with Figures 6b and c showing individual bolometer pixels.

Figure 7 is a graph showing dependence of growth rate v (Ångstrom/minute) of poly $Si_{11}Ge_{89}$ on deposition pressure p (Torr).

Figure 8 is a graph showing dependence of growth rate v (Å/min) (represented as diamonds) and germanium concentration (represented as squares) on silane flow rate Φ (sscm) for a deposition temperature of 400°C and a pressure of 2 Torr.

Figure 9 is a graph showing dependence of growth rate v (Ångstrom/minute) of poly $Si_{11}Ge_{89}$ on diborane flow rate Φ (sscm)

Figure 10 is a graph showing dependence of boron concentration N ($10^{20}$ $B/cm^3$) on diborane flow rate Φ (sscm) for poly $Si_{11}Ge_{89}$.

Figure 11 is a graph showing dependence of growth rate v (Å/min) of boron in situ doped silicon germanium on the germanium content N (%). The diborane flow has been fixed to 40 sccm.

Figure 12 is a graph showing XRD pattern I (a.u.) of $Si_{11}G_{89}$ deposited at 400°C and 0.6 Torr with the curve designated as "a" as-grown and with the curve designated as "b" annealed for 30 minutes at 450°C in nitrogen atmosphere. Curve "a" shows $Si_{11}Ge_{89}$ undoped, deposited at 400C, no anneal: no peak seen, so not-crystalline = amorphous. Curve "b" shows $Si_{11}Ge_{89}$ undoped, deposited at 400C, anneal at 450 no peak seen.

Figure 13 is a graph showing XRD pattern I (a.u.) of boron in situ doped $Si_{31}G_{69}$ deposited at 400°C and 2 Torr.

Figure 14 is a graph showing an XRD pattern I (a.u.) for boron in situ doped poly $Si_{31}Ge_{69}$ annealed at different temperatures with curve marked "a" as grown, curve marked "b" annealed at 450°C for 30 minutes and curve marked "c" annealed at 520°C for 30 minutes.

Figure 15 is a graph showing an XRD pattern I (a.u.) of poly $Si_{11}Ge_{89}$ having different boron concentrations and annealed at 520°C for 30 minutes with curve marked "a" undoped, curve "b" $2.76 \times 10^{19}$ Boron/cm$^3$, and curve "c" $3.75 \times 10^{20}$ Boron/cm$^3$. Curve "a" shows $Si_{11}Ge_{89}$ undoped, deposited at 400°C, anneal at 520°C: peaks are seen, so at least polycrystalline.

Figure 16 is a graph showing dependence of resistivity ρ (Ωcm) of poly $Si_{11}Ge_{89}$ deposited at 400°C and 2 Torr on boron concentration N ($10^{19}$ B/cm$^3$). Samples have been annealed for 30 minutes at 450°C.

Figure 17 is a graph showing dependence of resistivity ρ (Ωcm) of boron in situ doped SiGe on germanium concentration N (%). Diamonds represent as grown layers and squares represent layers annealed at 520°C for 30 minutes.

Figure 18 is a graph showing the effect of annealing temperature T (Celsius) on resistivity ρ (Ωcm) of boron in situ doped poly$Si_xGe_y$ having different germanium contents with x = 0.44, y = 0.56, (represented by diamonds), x = 0.35, y = 0.65, (represented by squares), x = 0.25, y = 0.75, (represented by stars), and x = 0.11, y = 0.89, (represented by circles).

Figure 19 is a graph showing dependence of sheet resistance $R_{sh}$(Ω/sq) on annealing temperature T (Celsius) for ion implanted silicon germanium layers having different germanium concentrations with x = 0.31, y = 0.69, (represented by stars), x = 0.11, y = 0.89, (represented by diamonds), and x = 0, y =1, (represented by squares).

Figure 20 is a graph showing XRD pattern I (a.u.) of boron ion implanted $Si_{31}Ge_{69}$ annealed at 450°C for 30 minutes.

Figure 21 is a graph showing dependence of sheet resistance $R_{sh}$ (Ω/sq) of 87 nm poly $Si_{31}Ge_{69}$ on annealing temperature T (Celsius) with as grown, (represented as squares), annealed at T=520°C for 30 minutes, (represented as diamonds), and annealed at T=650°C for 30 minutes, (represented as stars).

Figure 22 is a graph showing dependence of stress σ (MPa) on boron concentration N ($10^{19}$ B/cm$^3$) for $Si_{11}Ge_{89}$ deposited at 400°C and 2 Torr with squares representing as grown material and diamonds representing layers annealed at 450°C for 30 minutes in nitrogen atmosphere.

Figure 23 is a graph showing dependence of stress σ (MPa) on germanium concentration N (%) with squares representing as grown layers and diamonds representing layers annealed at 520°C for 30 minutes in nitrogen atmosphere.

Figures 24a-c are SEM pictures of cantilevers realized by boron in situ doped poly $Si_{31}Ge_{69}$ deposited at 400°C, with Figure 24a being as grown, Figure 24b being annealed at 450°C for 30 minutes and Figure 24c being annealed at 520°C for 30 minutes.

Figures 25a-c is a graph showing beam deflection d (um) as function of beam length 1 (um), with

Figure 25a showing grown poly $Si_{31}Ge_{69}$ cantilever profile;

Figure 25b showing cantilever profile for poly $Si_{31}Ge_{69}$ annealed at 450°C for 30 minutes; and

Figure 25c showing cantilever profile for poly $Si_{31}Ge_{69}$ annealed at 520°C for 30 minutes.

Figures 26a-c are SEM pictures of linear array of surface micromachined bolometers with

Figure 26a showing as grown, boron in situ doped poly $Si_{31}Ge_{69}$, deposited at 400 Celsius, 2 Torr;

Figure 26b showing poly $Si_{31}Ge_{69}$ annealed at 450°C for 30 minutes; and

Figure 26c showing poly $Si_{31}Ge_{69}$ annealed at 520°C for 30 minutes.

Figure 27 is a graph showing dependence of growth rate v (nm/min) of boron in situ doped $Si_{31}Ge_{69}$ deposited at 400°C on deposition plasma power P (W).

Figure 28 is a graph showing dependence of the stress σ (MPa) of boron in situ doped $Si_{31}Ge_{69}$ (deposited at 400°C) on annealing temperature T (Celsius) (30minutes in nitrogen atmosphere) for two plasma power, 30W (represented as squares) and 50W (represented as diamonds).

Figure 29 is a graph showing the effect of annealing temperature T (Celsius) and plasma power P (W) on resistivity ρ (Ωcm) of boron in-situ doped $Si_{31}Ge_{69}$ deposited at 400°C, with squares representing 30W and diamonds representing 50W.

Figure 30 is a graph of an XRD pattern I (a.u.) of $Si_{31}G_{69}$ deposited at 430°C (amorphous) and 590°C (partially polycrystalline).

Figure 31 is a graph of an XRD pattern I (a.u.) of as grown polycrystalline, in situ boron- and phosphor-doped SiGe deposited at 590°C.

Figure 32 is a graph of an XRD pattern I (a.u.) of as grown in situ phosphor-doped SiGe deposited at 590°C. Amorphous layer for 100sccm GeH4, while polycrystalline for 166sccm.

## Brief Description Of The Tables

Table 1: Deposition conditions used for poly Ge and poly SiGe.

Table 2. Summary of the as grown, in situ doped silicon germanium layers' characteristics.

Table 3: Effect of the phosphor concentration on the resistivity, stress and Ge concentration for 166sccm $GeH_4$ (deposition temperature 590°C).

Table 4: parameter range for obtaining low-stress poly-SiGe and preferred embodiments (which are shown in parentheses).

## Description of the invention

Control of stress and stress gradient in thin films is very important for free-standing micromachined structures. Such microstructures or floating microstructure elements are not mechanically supported by other elements or by underlying layers or substrate. These structures are only anchored to a substrate, e.g. only connected to the substrate at their perimeter or at some ends. The free-standing micromachined structures are, for example, constructed by the following. First, a sacrificial layer is deposited onto the substrate. This sacrificial layer may be composed of SiGe or other materials. The active or structural layer is then deposited onto the sacrificial layer. This active or structural layer, in a preferred embodiment, is composed of SiGe or entirely composed of Germanium. The sacrificial layer is then at least partially removed, and in a preferred embodiment, entirely removed. Stresses in the active or structural layer then may contribute to warping or bending when the support of the sacrificial layer is removed. Thus, stresses in the active or structural layer should be minimised.

Such microstructure devices or elements comprise layers that have ideally a low tensile stress and a zero stress gradient. Preferably, the stress is in the range of-100 MPa to +100 MPa. Preferably, the stress is in the range of-50 to +10 MPa. The plus-sign (+) denotes a tensile stress whereas the minus-sign (-) indicates a compressive stress in a layer. If the stress is compressive, structures can buckle. If the stress is too high tensile, structures can break. If the stress gradient is different from zero, microstructures can deform. For example, cantilevers can bend upwards if lower layers in a stack of layers exhibit a more compressive stress than upper layers in this stack of layers or if upper layers exhibit a more tensile stress than underlying layers. Free-standing structures can bend downwards if lower layers have more tensile stress than upper layers or upper layers have more compressive stress than underlying layers. Stresses can be intrinsic or extrinsic. Intrinsic stresses or growth stresses originate in the layer growth process itself, while extrinsic stresses or thermal stresses are due to the difference in thermal expansion between the structure and its surroundings. For example, between the layers in the structure and the substrate to which this structure is mechanically connected, a difference in thermal expansion coefficient might exist. This thermal mismatch can result from the post-deposition process history of a thin film. As the difference in thermal expansion coefficient of Si (3 ppm/Celsius) and Ge (6 ppm/Celsius) is relatively small, it is expected that the thermal stresses for structures comprising poly SiGe layers formed on top of a Si substrate are rather small. A major part of the mechanical stress present in these poly SiGe based structures is due to the growth process. How these poly SiGe growth processes should be tuned in order to get a low, preferably tensile, stress is not taught in the prior art. The deposition processes cited in the prior art are not intended for use in MEMS structures and therefore no measurements of stress or stress gradient are done. For the electronic performance of the devices, crystalline layers need to be obtained e.g. to have a low conductivity. However, no relationship exists for example between the crystal structure of the poly SiGe layer and the stress in such layers. In EP application EP 0 867 702, for example, an RPCVD deposition at 40 Torr and an APCVD deposition at atmospheric pressure in the same system resulted both in in-situ or as-deposited crystalline layers. The stress in the RPCVD layer however was low tensile while the stress in the APCVD layer was high compressive, making the RPCVD process a useful process for MEMS structures while the APCVD process could not be used. In the prior art examples, stress was never a parameter of the investigations. If an in-situ amorphous SiGe is made crystalline by performing an annealing step, such process of forming crystalline layers will most probably result in a huge tensile stress due to the volume reduction associated with this crystallisation process. It is therefore unknown if crystalline layers, which were grown for other purposes than for MEMS, have a low tensile stress or not.

The present invention deals with the development of low-stress poly-SiGe layers under different deposition conditions. Some deposition conditions examined, for example, include: deposition temperature; concentration of semiconductors (*e.g.*, the concentration of Silicon and Germanium in a $Si_xGe_{1-x}$ layer, with x being the concentration parameter); concentration of dopants (*e.g.*, the concentration of Boron or Phosphorous); amount of pressure; and use of plasma. These layers can be in-situ doped. Depositions with (PECVD) or without (CVD) plasma power were done at pressures between 300 mTorr and 760 Torr and wafer temperatures between 400 Celsius and 600 Celsius.

The minimum requirement for getting as-deposited low-stress layers is the development of an in-situ crystalline or partly crystalline layer. In one embodiment, the layer should be more than 30% crystalline. In an alternate embodiment, the layer should preferably be more than 40%. In still an alternate embodiment, the layer should preferably be more than 50%. And, in still another embodiment, the layer should preferably be above 60 or 70%. If the layers are substantially amorphous after deposition, subsequent crystallisation by annealing always gave rise to large tensile stresses making the layers unsuitable for surface micromachining. Thus, the common approach for both types of depositions was first to find the composition or temperature range where crystalline deposition would be possible. For enhancing the crystallization, both a large boron or phosphorous doping is used and/or the Ge content is increased.

In a first embodiment of a first aspect of the invention, parameters such as deposition temperature and concentration of semiconductors are analyzed. The first embodiment includes parameters which effect deposition for an undoped SiGe layer. As shown in Table 4, under the heading RPCVD, different parameters such as deposition temperature, pressure and germanium concentration are suggested. Ranges are given with preferred ranges in (parentheses). The subsequent discussion shows the effect of decreasing the deposition temperature of poly SiGe (for example from 650°C to 500°C on the growth rate) and the effect of modifying the germanium concentration in the SiGe layer on the structural and mechanical properties of the grown films is disclosed.

Poly SiGe has been deposited on eight-inch wafers using chemical vapor deposition (CVD) in an EPSILON I reactor, at pressures between atmospheric pressure (APCVD) and a reduced pressure (RPCVD) of 10 Torr. The reactor temperature was varied between 500 and 600 Celsius. In general, there is a difference between the reactor temperature set point and the actual wafer temperature. For some applications, it is important to determine the exact wafer temperature to avoid damaging devices or interconnects that might exist on the wafer. To determine the exact wafer temperature during deposition, phosphorus implanted p-type Si wafers have been annealed in a horizontal furnace for 30 minutes in nitrogen atmosphere at a temperature varying from 500°C to 650°C. In this case, the measured wafer temperature is accurate within $\pm 1$°C. The average measured sheet resistance of these wafers is displayed in Figure 1 (diamonds). These measurements can be used as a reference for the temperature calibration of the EPSILON reactor. The squares in Fig. 1, represents the sheet resistance of wafers placed in the reactor for 30 minutes in a hydrogen flow at a pressure of 40 Torr and a temperature of 550°C or 600°C. It is clear that the difference between the reactor temperature and the wafer increases by decreasing the reactor temperature. This might be due to the change in the heat transport characteristics from radiation to conduction at low temperatures. In general, for the temperature range under consideration, the difference between the wafer temperature and the reactor setting temperature is between 25°C and 40°C. Using this calibration method, the real wafer temperature during deposition is assessed.

10%/90% Germane/Hydrogen has been used as the germanium gas source, whereas, the silicon gas source is silane. The gas flow rate has been adjusted to yield a germanium concentration varying from 20% to 40% as determined by Rutherford Backscattering Spectroscopy (RBS). Figure 2 illustrates the dependence of the growth as function of deposition temperature for various silane flows. The deposition rate of RPCVD poly SiGe for a silane flow of 20 sccm (yielding a composition of $Si_{67}Ge_{33}$ at a reactor temperature of 550C) decreases from 110 Ångstrom/min to 42 Ångstrom/min if the deposition temperature is decreased from 600°C to 550°C. The process pressure was 40 Torr and the flow rate of silane and germane were fixed at 10 and 200 sccm, respectively. The deposition rate for 10 sccm silane (yielding a composition of $Si_{57}Ge_{43}$ at a reactor temperature of 550C) decreases from 75 Ångstrom/min to 42 Ångstrom/min if the deposition temperature is reduced from 600°C to 550°C. For pure germanium RPCVD films, the growth rate showed an increase from 2.8 Ångstrom/min to 6.4 Ångstrom/min by increasing the deposition temperature from 500°C to 580°C.

The texture and the transition temperature from amorphous to polycrystalline have been determined, for different germanium concentrations, deposition temperatures and deposition pressures, by means of X-ray diffraction spectroscopy (XRD) and are shown in Figures 3a-c and 4. The microcrystalline structure of the as-grown and of the subsequent annealed films has been investigated by transmission electron microscopy (TEM). All as-deposited layers are polycrystalline and their texture is nearly independent of the deposition temperature. Finally, the impact of the deposition temperature and germanium concentration on the SiGe stress is presented in Figure 5. This figure shows that stress in the material deposited at 550°C is always tensile, with poly Ge having the highest tensile stress, whereas, poly SiGe deposited with a silane flow of 10sccm (with a composition of poly $Si_{57}Ge_{43}$ at a reactor temperature of 550C) has the lowest tensile stress. It is shown that as-grown RPCVD poly SiGe, deposited at 550°C, has a tensile stress of 118 MPa. Such stress is suitable for micro machining applications as shown in Figure 6. Also, it is illustrated that by optimizing the deposition conditions, stress induced in as-grown films can be tuned to the desired value. Pure polycrystalline Ge will have an increase of stress with decreasing deposition temperature, making this material not very attractive for use in MEMS processing, certainly for use in post CMOS MEMS processing. Increasing the content of Ge in the deposited film, results in lower stress in the as-deposited film at lower deposition temperatures. Increasing the deposition temperature to 600°C, increases the stress to 150 MPa. On the other hand, stress in RPCVD poly Ge decrease from 257 MPa to 197 MPa by increasing the deposition temperature from 550°C to 580°C.

The SiGe can be deposited undoped and doping is done afterwards. One example of this type of doping is using ion implantation and a subsequent annealing step. Annealing can create or improve the fraction of crystalline material and can reduce the resistivity as as-implanted ions are not electrically active and do not contribute to electrical conduction. A temperature process step is thus necessary to "activate" the implanted ions and have them contribute to conduction. Parameters analysed include the concentration of the dopant and the temperature of the annealing step. In one example, the concentration of the dopant boron and the annealing temperature are analysed.

As shown in Table 4, under the heading RPCVD, different parameters such as deposition temperature, pressure, germanium concentration, boron concentration, and annealing temperature are suggested. Ranges are given with preferred ranges in (parentheses). The activation of boron implanted in the deposited SiGe is realised at a CMOS compatible temperature. In some applications, such as IR microbolometers, two different doping levels (high and low doping levels) are required and this can only be achieved by ion implantation. The as-grown layers are undoped and can later be doped to the desired dopant level. After implantation, an anneal is done to activate the dopants and the repair possible implantation damage in the SiGe layer. For such application, we investigated the impact of annealing temperature on ion implanted poly SiGe having a germanium content varying from 65% to 100% and ion implanted by a boron dose of $10^{16}$ Boron/$cm^2$ at an energy of 50 KeV. The SiGe layers are deposited using the process of the first embodiment of the second aspect of this invention. Figure 19 shows that for 90% germanium it is possible to activate the dopants and achieve a resistivity in the order of 0.3 mΩ.cm if the as-deposited layers are annealed at temperatures above 450 Celsius. The annealing in this example is done for 30 minutes in an nitrogen atmosphere. For layers comprising 70% Ge or lower, the dopants are activated at 520°C or higher. At 450°C, the layers are still amorphous as can be seen in the XRD pattern displayed in Figure 20, only showing the Si substrate peak. Thus, limiting the thermal budget to 450°C implies using a germanium concentration of 90% or higher. Figure 21 displays the dependence of sheet resistance of an 87 nm thick as-grown and of an annealed $Si_{31}Ge_{69}$ layers. It is clear that the dopants are activated at 520°C for 30 minutes, and the sheet resistance is almost unaffected by increasing the annealing temperature from 520°C to 650°C.

In a second aspect of the invention, two different deposition methods for in-situ doped low-stress poly-SiGe layers are disclosed. An overview of the process parameter range of the preferred embodiments is given in Table 4.

<u>CVD deposition</u>

In a first embodiment of this aspect of the present invention, a CVD deposition method without the use of plasma is disclosed. The avoidance of a plasma allows the deposition of polycrystalline low-stress SiGe layers suitable for surface micromachining applications at a CMOS compatible temperature. As shown in Table 4, under the heading CVD, different parameters such as deposition temperature, pressure, germanium concentration, and doping concentration (*e.g.*, Boron) are suggested with preferred parameters in parentheses. The following discussion elaborates on these different parameters.

Silicon Germanium has been deposited in an OPT Plasma Lab 100 system, which is a PECVD cold wall system. The silicon gas source is pure silane, whereas 10% germane in hydrogen has been used as the germanium gas source. 1% diborane in hydrogen has been used as the boron gas source. Films have been deposited on six-inch silicon wafers having 170 nm of PECVD silicon oxide. To enhance nucleation of silicon germanium on top of silicon oxide, PECVD amorphous silicon has been deposited, during one minute, using a mixture of 1000 sccm (standard cubic centimeter: volume at standard atmospheric pressure, 101 kPa, and a temperature of 293K) hydrogen and 50 sccm silane at 60 W and 0.6 Torr. The deposition temperature of silicon germanium has been fixed to 400 Celsius, whereas the deposition pressure has been varied from 0.3 Torr to 2 Torr. The power has been set to 0 W. The germanium flow rate has been fixed to 166 sccm for all depositions, whereas, the silane flow rate has been varied from 0 to 100 sccm to yield a germanium content varying from 100% to 52.6% as determined by Rutherford Back Scattering (RBS). The diborane flow rate has been varied from 0 to 40 sccm. Boron concentration has been determined by Secondary Ion Mass Spectroscopy (SIMS) and has been found to vary from $3.45\times10^{19}$ Boron/$cm^3$ to $4.68\times10^{20}$ Boron/$cm^3$.X-ray diffraction spectroscopy (XRD) has been used to determine the texture of the deposited layers. The layer thickness has been measured using a mask etch of silicon germanium and silicon oxide and measuring the step height using DEKTAK, a surface profiler. Stress has been determined by measuring the bow of the wafer before and after depositing the layers using an Eichorn & Hausmann MX 203 stressmeter. Sheet resistance has been measured using four-point probe on 49 different locations on the wafer.

<u>IMPACT OF DEPOSITION PRESSURE ON GROWTH RATE</u>

The impact of deposition pressure on growth rate of poly $Si_{11}Ge_{89}$ deposited at 400°C is displayed in Figure 7. It is clear from the figure that increasing the deposition pressure from 0.3 Torr to 2 Torr significantly increases the growth rate. Consequently, for most of the analysis, the deposition pressure to 2 Torr is fixed to obtain the highest working speed.

IMPACT OF SILANE FLOW ON GROWTH RATE AND GERMANIUM CONTENT

Figure 8 demonstrates the impact of silane flow on germanium content and growth rate. It is clear from the figure that the measured germanium concentration (x) and growth rate (GR) varies logarithmically with the silane flow rate (SFR) according to the following experimentally fitted expressions:

$$x = 111.77 - 12.86\ln(SFR) \quad [\%] \qquad (1)$$

$$GR = 28.7 - 6.1\ln(SFR) \quad [\text{Å/min}\} \qquad (2)$$

IMPACT OF DIBORANE FLOW ON GROWTH RATE

Figure 9 shows that introducing diborane initially slightly decrease the growth rate, which might be due to the decrease in the partial pressure of germane. Further increasing the diborane flow enhances the growth rate and for 40 sccm diborane, the growth rate is almost doubled. The dependence of the boron concentration in the deposited film on the diborane flow rate is illustrated in Figure 10. As expected, the boron content in the deposited $Si_xGe_y$ layer increases with increased diborane flow.

The impact of varying the germanium content on growth rate for a fixed diborane flow is illustrated in Figure 11. Decreasing the germanium content from 90% to 69% increases the growth rate from 32 Å/min to 42 Å/min. Further decrease in the germanium content results in a decrease in the growth rate.

TEXTURE OF SILICON GERMANIUM DEPOSITED AT 400°C

The texture of the deposited layers has been investigated by X-ray Diffraction Spectroscopy (XRD). It has been noticed that undoped layers are always amorphous, independent of the germanium content. Doped layers show an initial solid phase crystallisation. The temperature at which this initial crystallisation will start depends on the *in-situ* doping of the layers. Solid phase crystallization of undoped $Si_xGe_y$ layer for a germanium content of 70% (Y>0.7) or higher can be achieved by annealing for 30 minutes at 450°C as clear from Figure 12. Curve "a" in Figure 12 shows the texture of an undoped as-deposited layer and no polycrystalline peaks can be seen. As shown in curve "b" in Figure 12, after anneal different crystal orientations are obtained within the SiGe layer and a cryrstalline layer is formed. It has been noticed that adding diborane to the deposition gases promotes the crystallization of the as grown layers as clear from the XRD pattern displayed in Figure 13. For a diborane flow rate of 40 sccm, which corresponds to a boron concentration of $4.68 \times 10^{20}$ Boron/cm$^3$, the as-grown layers have polycrystalline peaks for a germanium content as low as 69%, even for a deposition temperature as low as 400 Celsius (see Figure 13). The impact of annealing temperature on the texture of this *in situ* boron-doped poly $Si_{31}Ge_{69}$ is demonstrated in Figure 14. Curve "a" in Figure 14 shows the as-deposited in-situ doped polycrystalline SiGe layer. Subsequent annealing in nitrogen for 30 minutes at 450 Celsius (curve "b" in Figure 14) or 520 Celsius (curve "c" in Figure 14) increases the degree of crystallinity in the layer. As can be concluded from the presence of the diffraction peaks at the different family of lattice planes other then the {311} peak of the Si substrate the material is at least partially crystalline. The increase of the peaks correspond to an increase in the fraction of crystalline material in the layer. The influence of boron concentration on texture of poly $Si_{11}Ge_{89}$ is presented in Figure 15. Undoped poly $Si_{11}Ge_{89}$ deposited at 400 Celsius was amorphous (see curve "a" in Figure 12), but at 520 Celsius anneal the undoped layer will be polycrystalline at deposition (curve "a" in Figure 15) thanks to the high amount of germanium present in the layer. Adding boron will for the given annealing temperature of 520 Celsius further yield higher polycrystalline peaks for the as-deposited crystalline material.

ELECTRICAL PROPERTIES OF SILICON GERMANIUM DEPOSITED AT 400°C

Figure 16 displays the dependence of resistivity of in situ boron-doped poly $Si_{11}Ge_{89}$ deposited at 400 Celsius and 2 Torr on boron concentration (see curve "b" in Figure 14 for information on the corresponding texture). Samples have been annealed at 450°C for 30 minutes in a nitrogen atmosphere. The dependence of resistivity on germanium concentration is demonstrated in Figure 17. The "diamond" line represent the as-grown in-situ doped SiGe layer deposited at 400 Celsius, while the squares represent the layers after annealing in nitrogen at 520 Celsius. Figure 17 shows the critical germanium concentration below which the deposited layers are amorphous as this can be inferred from the abrupt change in resistivity at a germanium content of about 65%. The resistivity of as grown $Si_{x5}Ge_y$, with y >0.65, might indicate that these layers are partially crystalline, whereas the high resistivity observed for lower germanium concentrations (Y<0.65) shows that these layers are amorphous. Even annealing at 520°C for 30 minutes is not enough to transform these as-deposited amorphous layers into crystalline layers. To determine the annealing temperature required to crystallize layers having different germanium concentrations we refer to Figure 18. Increasing the germanium content from 56% to 65% will shift the threshold temperature i.e. the annealing temperature above which a polycrystalline layer is obtained, from 600 Celsius down to 530 Celsius. Further increasing the germanium content will result in an as-deposited polycrystalline SiGe layer, whose resistivity is relative insensitive to subsequent annealing.

MECHANICAL PROPERTIES OF SILICON GERMANIUM DEPOSITED AT 400°C

The dependence of stress on boron concentration for as grown and annealed $Si_{11}Ge_{89}$ deposited at 400°C and 2 Torr is demonstrated in figure 22. The corresponding resistivity curve is shown in Figure 16. From Figure 16, it was concluded that the SiGe layer is crystalline as indicated by the low resistivity, but as noticed already in the first aspect of the invention, this low resistivity does not imply that a low stress is obtained in the as-deposited layer. Increasing the boron concentration will yield an in-situ boron doped polycrystalline SiGe layer with decreasing stress. A subsequent short anneal, e.g. 450 Celsius in nitrogen for 30 minutes, will for the same boron concentration result in a higher stress compared to the as-deposited layer. Also, the dependence of stress on germanium concentration is displayed in Figure 23. As shown for the resistivity in Figure 17 for these samples, the increase in germanium content above the threshold will yield as-deposited polycrystalline layers having a low stress. A subsequent anneal did not vary the resistivity for $Si_{11}Ge_{89}$, as shown in Figure 18, but results in an increase in compressive stress. The changes in stress in poly $Si_{31}Ge_{69}$ are mainly due to the change in stress gradient. Figure 24 clarifies this issue for an in-situ doped $Si_{31}Ge_{69}$ layer deposited a 400 Celsius. Cantilevers realised by the as grown material are initially bending upwards (see Figure 24a), which is in agreement with the measured tensile stress shown in Figure 23. Whereas, the far end is strongly bending upwards, indicating that the upper layer are much more tensile than the lower ones. Figure 25a shows that 75 μm long cantilevers are bending by more than 12 μm (this profile has been determined by scanning the cantilever surface using a 5 nm wide laser beam). Annealing at 450°C for 30 minutes, significantly reduce the mean stress as clear from the initial slope of the cantilevers (see Figures 24b and 25b). It is interesting to note that in this case 600 μm long cantilevers are bending upwards by 14 μm indicating that the upper layers are still more tensile than the lower ones but the stress gradient is much less than that of the as-grown material. Increasing the annealing temperature to 520°C, results in a severe change in the stress gradient as is clear from the cantilevers displayed in Figure 24c. In this case, the upper layers are more compressed than the lower ones, and the profile displayed in Figure 25c shows that 800 μm long cantilevers are bending downwards by more than 130 μm. Thus, in case of high stress gradient, the mean stress determined by measuring the bow of the wafer before and after deposition is in some cases misleading.

To have an idea of the impact of stress in boron in situ doped poly $Si_{31}Ge_{69}$ on the stability of surface micromachined structures we refer to Figure 26, where we display an SEM picture for a linear array of surface micromachined bolometers. In spite of the high mean stress and stress gradient in as-grown poly SiGe, the structures are suspended with 100% yield (see Figure 26a). Structures annealed at 450 Celsius are completely flat as clear from Figure 26b. Whereas, Figure 26c shows that annealing at 520 Celsius results in severe bending of the structures towards the substrate and consequently they will not be suitable for surface micromachining. In Figure 24a, the cantilevers formed at the same conditions of the bolometer array in Figure 24a are bending upwards, possibly due to the stress gradient. Annealing the device at 450 Celsius result in flat substantial horizontal cantilevers. An anneal at a temperature of 520 instead of 450 Celsius will yield cantilevers bending towards the surface of the substrate. Thus, it is possible to realize surface micromachined structures at 450°C having a resistivity as low as 1mΩ.cm, not suffering from deformation due to stress or stress gradient.

PECVD deposition

In a second embodiment of this aspect of the present invention, a CVD deposition method is disclosed whereby this method uses plasma (PECVD). Compared to thermally grown layers as disclosed in the first embodiment of this second aspect, plasma-enhanced deposition gives the possibility of direct deposition on Si-oxide, without the use of a nucleation layer. PECVD allows the deposition of SiGe layers suitable for surface micromachining applications at CMOS compatible temperatures or higher temperatures. As shown in Table 4, under the heading PECVD, different parameters such as deposition temperature, pressure, germanium concentration, and doping concentration (*e.g.*, Phosphorous) are suggested with preferred parameters in parentheses. The following discussion elaborates on these different parameters.

PECVD offers a higher deposition rate compared to the thermal deposition processes. The calibration of the wafer temperature was done with a thermocouple wafer at a pressure of 2 Torr (pure hydrogen). Silicon Germanium has been deposited in an Oxford Plasma Technology (OPT) Plasma Lab 100 system, which is a PECVD cold wall system. The silicon gas source is pure silane, whereas 10% germane in hydrogen has been used as the germanium gas source. 1% diborane in hydrogen has been used as the boron gas source, and 1% phosphine in silane has been used as the phosphor gas source. Films have been deposited on six-inch silicon wafers having 100 nm or 220 nm of PECVD silicon oxide. When a nucleation layer was used on top of silicon oxide, PECVD amorphous silicon has been deposited, for one minute, using a mixture of 1000 sccm hydrogen and 50 sccm silane at 60 W and 1 Torr.

The deposition of boron-doped silicon germanium has been done at wafer temperatures of 430°C and 590°C. The deposition pressure has been fixed at 2 Torr and the power at 30 W. The germane flow rate was 166 sccm, the silane flow rate 30sccm and the diborane flow rate 40 sccm. The silicon concentration X is 39% and the germanium concentration Y is 61 % as determined by Rutherford Back Scattering (RBS).

The deposition of phosphor-doped silicon germanium has been done at a wafer temperature of 590°C. The deposition pressure has been fixed at 2 Torr and the power at 30 W. The silane flow rate has been fixed at 30 sccm, whereas germane flows of 100 sccm and 166 sccm have been used to yield a germanium content between 34 and 46 % as determined by Rutherford Back Scattering (RBS). The phosphine flow rate has been varied as 40sccm, 60sccm and 80sccm. Phosphor concentrations have been determined by Secondary Ion Mass Spectroscopy (SIMS) and, for a germane flow of 100sccm, have been found to be $6.8x10^{20}$, $9x10^{20}$, $1x10^{21}$ Phosphor/$cm^3$ for 40sccm, 60sccm and 80sccm germane flow, respectively. Crystallinity of the deposited layers has been determined by using X-ray diffraction spectroscopy (XRD) and/or by measuring the sheet resistance. The layer thickness has been measured using a mask etch of silicon germanium and measuring the step height using a surface profiler. Stress has been determined by measuring the bow of the wafer before and after depositing the layers using an Eichorn & Hausmann MX 203 stressmeter. Sheet resistance has been measured using a four-point probe on different locations on the wafer. An overview of the characteristics of the deposited layers is given in table 2.

Impact of Plasma Power on Growth Rate

The impact of deposition power on the growth rate of poly $Si_{31}Ge_{69}$ deposited at 400°C is displayed in Figure 27. Increasing the deposition power from 0 W to 50 W changes the growth rate dramatically, from 3.7 nm/min to 138 nm/min. However, for a power higher than 20W, the increase in the deposition rate is not so significant. Therefore, for all the depositions, we fix the deposition plasma power to 30 W to obtain a high deposition rate.

Impact of Annealing Temperature and Plasma Power on Stress

The dependence of stress on annealing temperature and plasma power is demonstrated in Figure 28. Good stress values are obtained for in-situ B-doped $Si_{31}Ge_{69}$ layers, deposited at 400 Celsius, annealed at low temperatures: 450 Celsius anneal results +43MPa and +41MPa for 30W and 50W, respectively; 520 Celsius anneal results in +187MPa and +117MPa for 30W and 50W, respectively. High stress is obtained if the layers are annealed at high temperatures: at 600 Celsius anneal temperature +587MPa and +337MPa are measured for 30W and 50W, respectively. At this temperature there are however also problems with cracks/pinholes in the plasma-deposited layers due to crystallization/H-release. For annealing temperatures higher than 450°C, the 30W power gives higher tensile stress.

Impact Of Annealing Temperature And Plasma Power On Crystallinity / Resistance

It has been noticed that there is a direct correlation between the resistivity of in-situ doped silicon germanium layers and their crystallinity. A high resistivity is observed for amorphous layers, while partial crystalline or crystalline layers have a low resistivity (see Figure 29 and Figure 16 together with Figure 22). In this way, the crystallinity of the layers may be determined by both XRD and resistivity measurements.

Figure 29 displays the dependence of resistivity of in-situ boron doped poly $Si_{31}Ge_{69}$ deposited at 400°C on annealing temperature and plasma power. As grown layers without plasma (0 W) give a low resistivity (0.0027Ω.cm) compared to as grown layers obtained using plasma: 13.7Ω.cm and 24.2Ω.cm for 30W and 50W, respectively. Low resistivity can be reached after subsequent annealing at higher temperature (600°C: 0.0023Ω.cm and 0.008Ω.cm for 30W and 50W, respectively).

From Figures 28 and 29, one can conclude that PECVD layers deposited at 400 Celsius, if annealed at low temperature (450 to 520 Celsius), have good stress values but then with a high resistivity. Low resistivity but high stress is obtained for PECVD layers annealed at high T (600°C). This can be explained by the fact that the as-deposited amorphous films are crystallized during the 600 C anneal. Therefore, a higher deposition temperature is necessary to obtain in situ polycrystalline layers with good stress and resistivity.

Impact Of Deposition Temperature And Ge Concentration On The Stress

In the summarizing table 2, it can be observed that indeed there is a dependency of the stress on the deposition temperature and the germanium concentration. As grown, in situ boron-doped silicon germanium deposited at 430°C is amorphous as indicated by the very high resistivity, and has a compressive stress (-120MPa), while if deposited at 590°C the layers are, at least partially, polycrystalline with a tensile stress (+75MPa). Similarly, the germanium concentration determines whether an as grown layer is, at least partially, polycrystalline or not. Phosphor-doped (40 sccm phosphine flow) silicon germanium layers deposited at 590°C are amorphous for a 100 sccm $GeH_4$ flow rate displaying a compressive stress (-140MPa), while these layers are, at least partially, crystalline for a 166 sccm $GeH_4$ flow rate having a tensile stress (+75MPa). Low stress and low resistivity layers can be obtained for both types of dopant (boron or phosphor) if the temperature and the germane flow rate are high enough. The deposition temperature is preferably above 450 Celsius and the germanium flow rate is preferably above 100 sscm.

CRYSTALLINITY OF SILICON GERMANIUM DEPOSITED AT 590°C

The impact of deposition temperature on the crystallinity of as grown PECVD boron *in situ* doped $Si_{31}Ge_{69}$ is demonstrated in Figure 30. At 430°C, the layers are amorphous, while at 590°C they are polycrystalline. The (111), (220) and (311) peaks are the most important crystalline peaks. As grown polycrystalline layers deposited at 590°C are obtained for both types of dopant, boron (40 sccm diborane) or phosphor (80 sccm phosphine) as shown in Figure 31. By changing the germanium concentration, amorphous (100sccm GeH4 flow rate) or polycrystalline (160sccm GeH4 flow rate) layers are obtained (for 80 sccm phosphine), as shown in Figure 32.

Impact Of Phosphine Flow On The Stress And Resistivity

The concentration of the phosphor dopant has been varied by changing the phosphine flow (80sccm, 60sccm and 40sccm) and by keeping the germane flow constant. This change in phosphine flow does not have any effect on the resistivity of the layers as shown in table 3. As shown for low stress and polycrystalline layers, preferably deposited at temperatures at or above 550 Celsius, one can use phosphor concentrations corresponding to a phopshine flow ranging from 40 to 80 sscm, since in this phosphine flow range, the mechanical stress is 100MPa or least, and hence can be considered as very well suited for MEMS applications. However, for a phosphine flow of 40sccm or less, the deposited polySiGe layer comprises less silicon, so the final structure might less strong or robust.

Impact Of The Nuceation Layer On The Properties Of The Layers

For all the depositions, the quality of the film is not influenced by the presence of the amorphous Si nucleation layer. A nucleation layer can be used for the PECVD deposition, but this is not necessary.

Tables

Table 1: Deposition conditions used for poly Ge and poly SiGe

| Dep. Temp. | Dep. Pressure | Silane Flow | Germane Flow | Ge conc. | Dep. Time | Layer thickness |
|---|---|---|---|---|---|---|
| 550°C | 40 Torr | 0 | 200 sccm | 100% | 3h | 368 nm |
| 550°C | 40 Torr | 10 sccm | 200 sccm | 43% | 1h 40’ | 415 nm |
| 550°C | 40 Torr | 20 sccm | 200 sccm | 34% | 1 h 30’ | 337 nm |
| 580°C | 40 Torr | 0 | 200 sccm | 100% | 2h | 336 nm |
| 580°C | 40 Torr | 10 sccm | 200 sccm | 43% | 1h | 338 nm |
| 580°C | 40 Torr | 20 sccm | 200 sccm | 32% | 50’ | 270 nm |
| 600°C | 40 Torr | 0 sccm | 200 sccm | 100% | 2 h | 465 nm |
| 600°C | 40 Torr | 10 sccm | 200 sccm | 43% | 40’ | 300 nm |

Table 2. Summary of the characteristics as grown, in situ doped silicon germanium layers deposited by a PECVD method.

| In situ dopant | Characteristics | Deposition T **430°C** | Deposition T **590°C** | |
|---|---|---|---|---|
| Boron | Stress [MPa] | -120 | +100 | |
| | Resistivity [Ω.cm] | very high | 0.0006 | |
| | Deposition rate [nm/min] | 100 | 130 | |
| Phosphor | $GeH_4$ flow rate [sccm] | | 100 | 166 |
| | Stress [MPa] | | -140 | +75 |
| | Resistivity [Ω.cm] | | very high | 0.002 |
| | Ge % | | 35 | 46 |
| | Si % | | 65 | 52 |
| | Deposition rate [nm/min] | | 200* | 200* |
| ** phosphine is in silane while diborane is in hydrogen, thus there is more silane for the phosphor-doped layers which means a higher deposition rate.* | | | | |

Table 3: Effect of the phosphor concentration on the resistivity, stress and Ge concentration for 166sccm GeH4.

| 1%$PH_3$ in $SiH_4$ [sccm] | 80 | 60 | 40 |
|---|---|---|---|
| Ge concentration (%) | 34 | 42 | 46 |
| Tensile stress σ [MPa] | <100 | 100 | 70 |
| Resistivity ρ [Ω.cm] | 0.025 | 0.025 | 0.02 |

Table 4: parameter range for obtaining low-stress poly-SiGe and preferred embodiments

| **Parameter** | **Units** | **Range** | **RPCVD** | **CVD** | **PECVD** |
|---|---|---|---|---|---|
| Temperature T | °C | 400 - 570...800 | 500≤T≤550<br>(T≈500) | T≤500<br>(400≤T≤450) | T≥430<br>(430≤T≤470, good stress, acceptable resistivity)<br>(550≤T≤590, good stress, good resistivity) |
| Power PW | W | 0-50...200 | 0 | 0 | 20≤PW≤50<br>(30 ≤PW≤50) |
| Pressure P | Torr | 0.1....0.3 - 2 ....760 | 10-760<br>(10-100) | .3≤P≤10<br>(0.3≤P≤2) | 1≤P≤5<br>(2≤P≤4) |
| Ge-concentration N | % | 10....34-100 | 30-100<br>(≥40) | 30≤N≤100<br>(52.6 ≤N≤100) | 34≤N≤61<br>(34 ≤N≤46) |
| B-concentration N | /$cm^3$ | 0-4.68x$10^{20}$ | N≥1X$10^{16}$<br>(3X$10^{16}$≤N≤ 12X$10^{16}$) | 0 ≤N≤4.68x$10^{20}$<br>(2X$10^{20}$≤N≤ 5X$10^{20}$) | |
| Anneal A | °C | | A≥450<br>(4505≤A≤520) | A≥450<br>(450≤A≤520) | |
| P-concentration N | /$cm^3$ | | | | $10^{20}$≤N≤10x$10^{20}$<br>(6X$10^{20}$≤N≤ 10X$10^{20}$) |

(continued)

| Parameter | Units | Range | RPCVD | CVD | PECVD |
|---|---|---|---|---|---|
| Nuclation layer | | Yes or no | | yes | Yes or no |

## Claims

1. A method of controlling the stress in a polycrystalline SiGe layer deposited on a substrate, the method comprising the steps of:

   - depositing onto the substrate a sacrificial layer;
   - depositing onto the sacrificial layer a layer of silicon-germanium ($Si_{1-x}Ge_x$), wherein $0.3 \leq x \leq 1$, and wherein the step of depositing is performed by chemical vapour deposition at a deposition temperature (T) between 400°C and 500°C, and at a deposition pressure (P) between 0.3 Torr and 10 Torr and wherein the layer of silicon-germanium is doped with a dopant during the step of depositing the layer of silicon-germanium, the dopant being Boron and wherein the concentration of Boron is between $2x10^{20}$ and $5x10^{20}/cm^3$.
   - removing at least a portion of the sacrificial layer.

2. The method of claim 1, wherein the deposition pressure is $.3$ Torr $\leq P \leq 2$ Torr.

3. The method of claim 1, wherein $.526 \leq x \leq 1.0$.

4. The method of claim 1, further comprising the step of annealing the layer of silicon-germanium, the step of annealing being performed at a temperature greater than or equal to 450°C.

5. The method of claim 4, wherein the temperature to perform the step of annealing is greater than or equal to 450°C and less than or equal to 520°C.

## Patentansprüche

1. Verfahren zur Regelung der Verspannung in einer polykristallinen SiGe-Schicht, die auf ein Substrat aufgebracht wird, wobei das Verfahren die folgenden Schritte umfasst:

   - Aufbringen einer Opferschicht auf das Substrat;
   - Aufbringen einer Schicht aus Silicium-Germanium ($Si_{1-x}Ge_x$) auf die Opferschicht, wobei $0,3 \leq x \leq 1$ und wobei der Schritt des Aufbringens durch chemische Abscheidung aus der Gasphase bei einer Abscheidungstemperatur (T) von 400 °C bis 500 °C und einem Abscheidungsdruck von 0,3 Torr bis 10 Torr durchgeführt wird, und wobei die Silicium-Germanium-Schicht während des Schrittes des Abscheidens der Silicium-Germanium-Schicht mit einem Dotierstoff dotiert wird, wobei es sich bei dem Dotierstoff um Bor handelt und die Konzentration des Bors von $2x10^{20}$ bis $5x10^{20}/cm^3$ beträgt;
   - Entfernen zumindest eines Abschnitts der Opferschicht.

2. Verfahren nach Anspruch 1, wobei für den Abscheidungsdruck 0,3 Torr $\leq P \leq$ 2 Torr gilt.

3. Verfahren nach Anspruch 1, wobei $0,526 \leq x \leq 1,0$.

4. Verfahren nach Anspruch 1, welches ferner den Schritt des Temperns der Silicium-Germanium-Schicht umfasst, wobei der Temperschritt bei einer Temperatur größer oder gleich 450 °C durchgeführt wird.

5. Verfahren nach Anspruch 4, wobei die Temperatur bei Durchführung des Temperschrittes größer oder gleich 450 °C und kleiner oder gleich 520 °C ist.

## Revendications

1. Procédé pour contrôler la contrainte dans une couche de SiGe polycristallin déposée sur un substrat, le procédé comprenant les étapes consistant à :

- déposer une couche sacrificielle sur le substrat ;
- déposer une couche de silicium-germanium ($Si_{1-x}Ge_x$) sur la couche sacrificielle, où $0,3 \leq x \leq 1$, et où l'étape de dépôt est réalisée par dépôt chimique en phase vapeur à une température de dépôt (T) comprise entre 400 °C et 500 °C et à une pression de dépôt (P) comprise entre 0,3 Torr et 10 Torr et où la couche de silicium-germanium est dopée avec un dopant pendant l'étape de dépôt de la couche de silicium-germanium, le dopant étant du bore et où la concentration en bore est comprise entre $2 \times 10^{20}$ et $5 \times 10^{20}/cm^3$ ;
- éliminer au moins une partie de la couche sacrificielle.

**2.** Procédé selon la revendication 1, dans lequel la pression de dépôt est 0,3 Torr $\leq P \leq$ 2 Torr.

**3.** Procédé selon la revendication 1, dans lequel $0,526 \leq x \leq 1,0$.

**4.** Procédé selon la revendication 1, comprenant en outre l'étape de recuit de la couche de silicium-germanium, l'étape de recuit étant réalisée à une température supérieure ou égale à 450 °C.

**5.** Procédé selon la revendication 4, dans lequel la température pour réaliser l'étape de recuit est supérieure ou égale à 450 °C et inférieure ou égale à 520 °C.

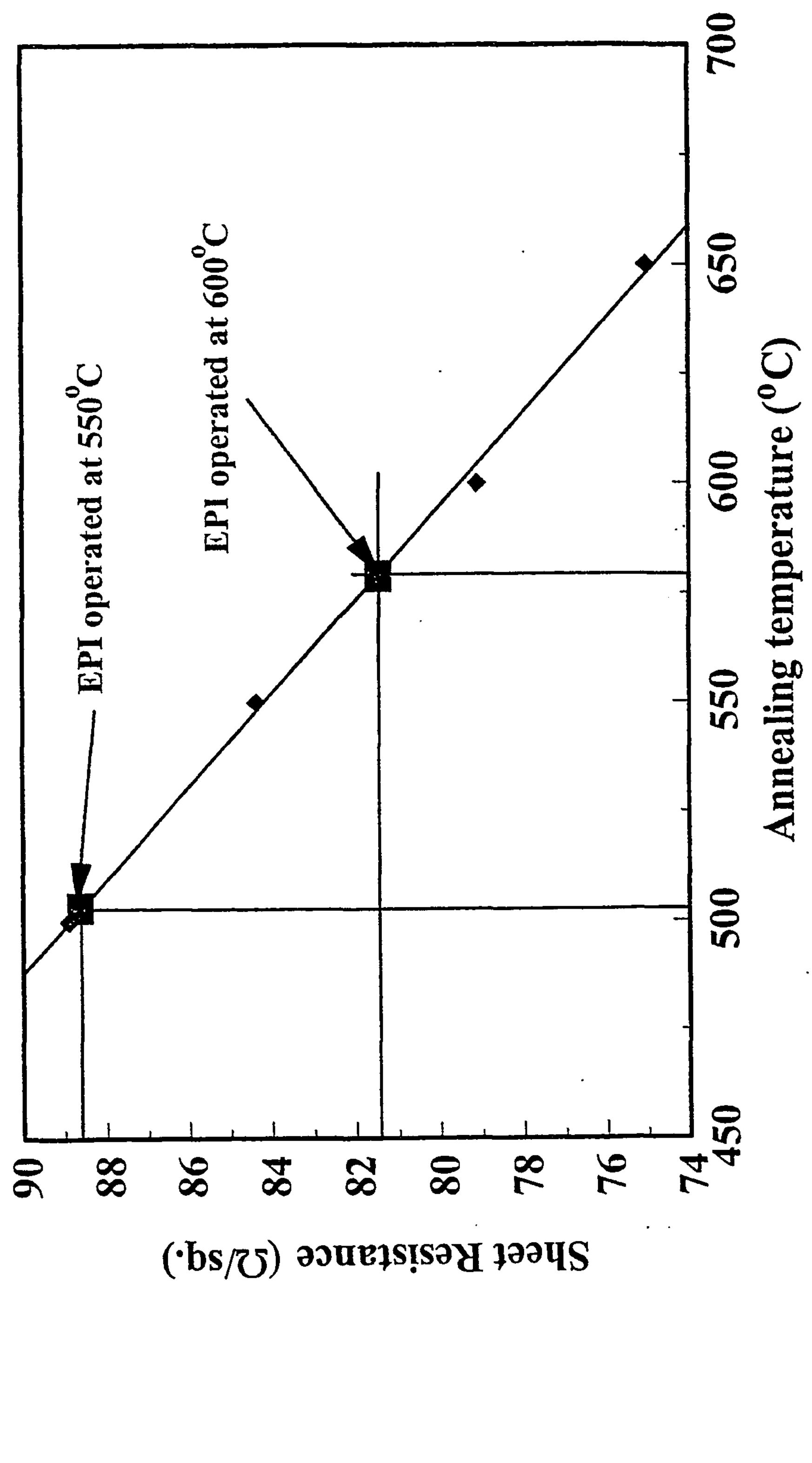
EPI operated at 550$^0$C
EPI operated at 600$^0$C
Sheet Resistance (Ω/sq.)
90
88
86
84
82
80
78
76
74
450
500
550
600
650
700
Annealing temperature ($^0$C)

Figure 1

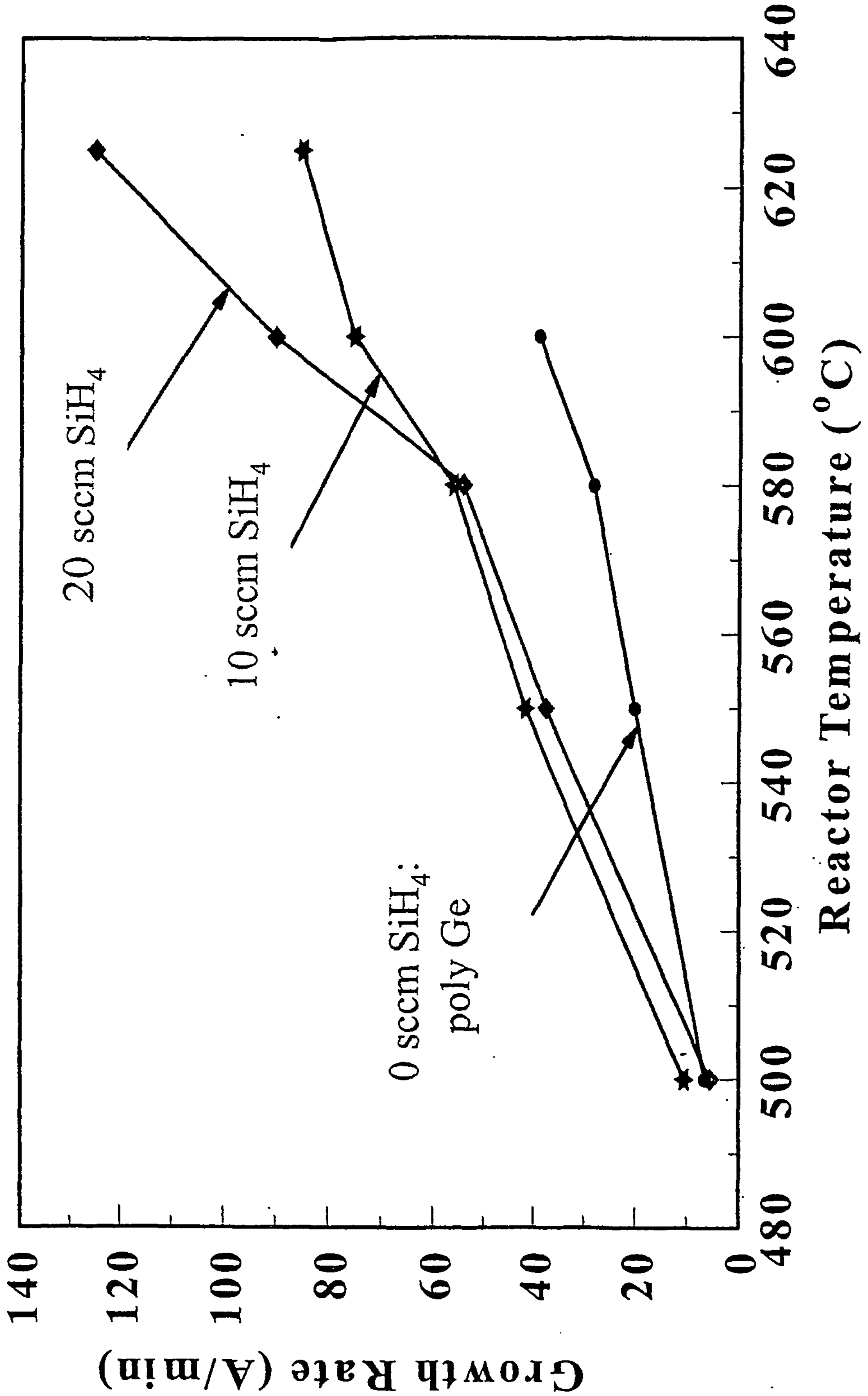

20 sccm $SiH_4$
10 sccm $SiH_4$
0 sccm $SiH_4$:
poly Ge
Growth Rate (Å/min)
0
20
40
60
80
100
120
140
480
500
520
540
560
580
600
620
640
Reactor Temperature (°C)


Figure 2

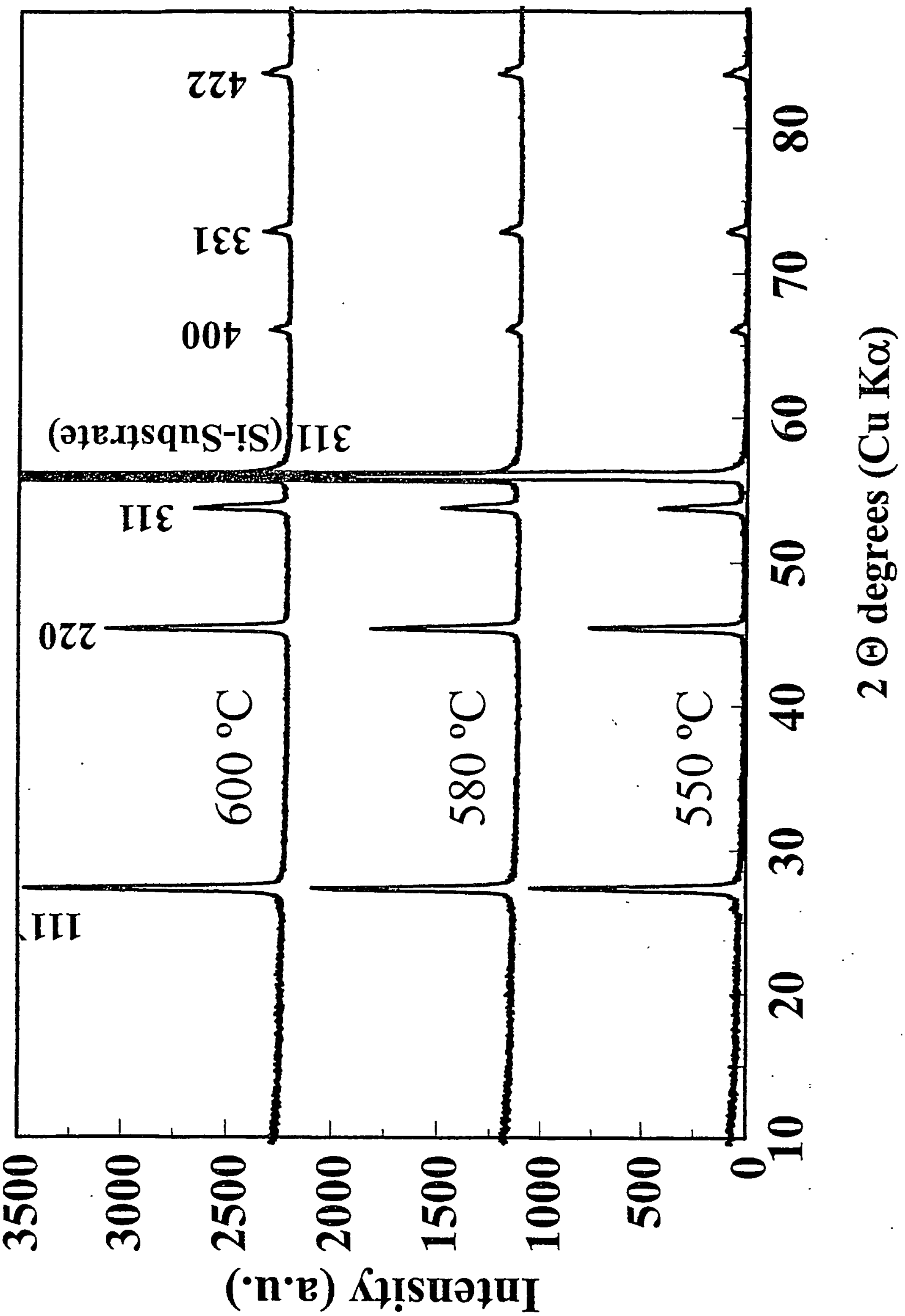


Figure 3a 0 sccm silane

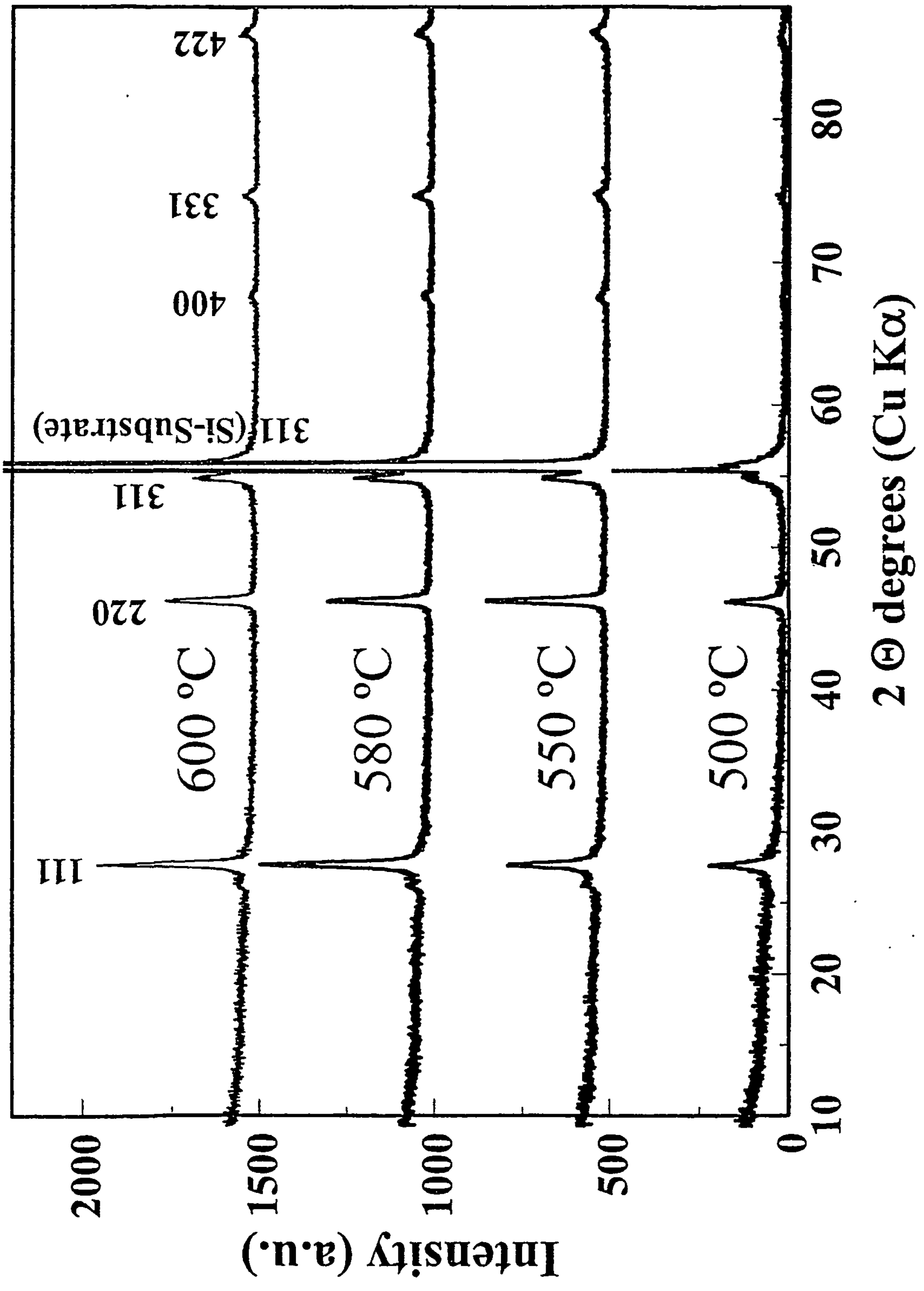


Figure 3b 10 sccm silane

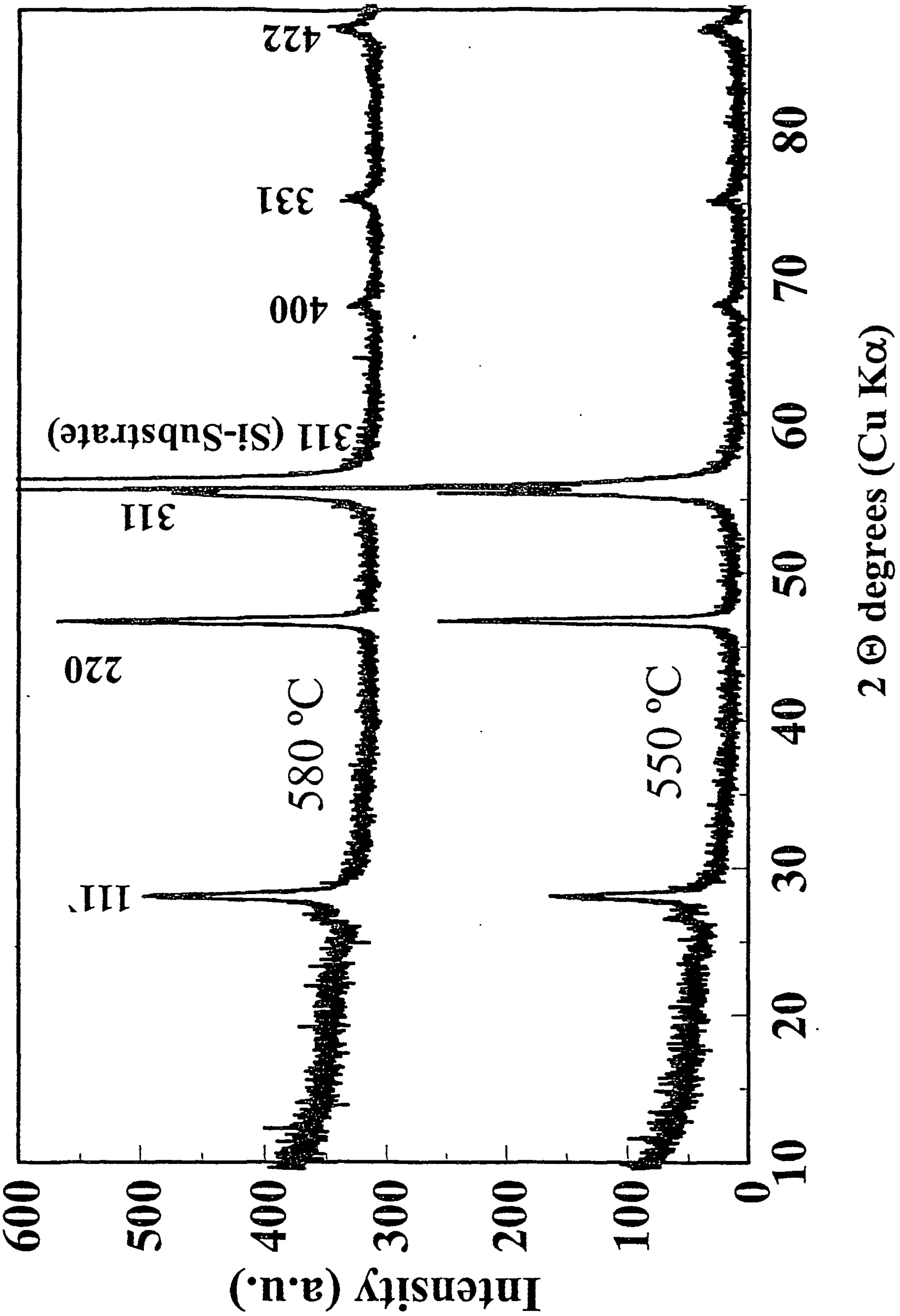


Figure 3c 20 sccm silane

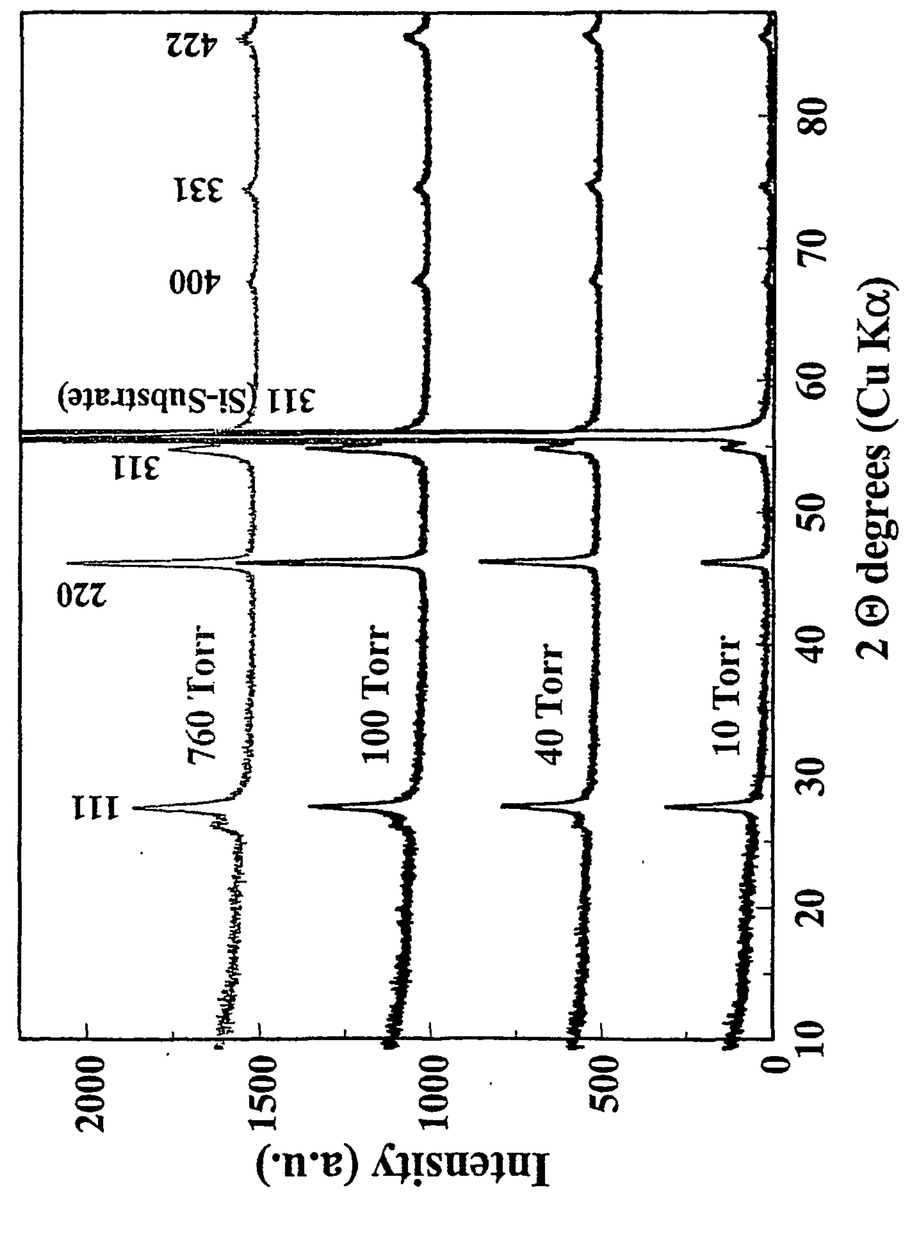
Intensity (a.u.)
2000
1500
1000
500
0
10
20
30
40
50
60
70
80
2 Θ degrees (Cu Kα)
111
220
311
311 (Si-Substrate)
400
331
422
760 Torr
100 Torr
40 Torr
10 Torr

Figure 4

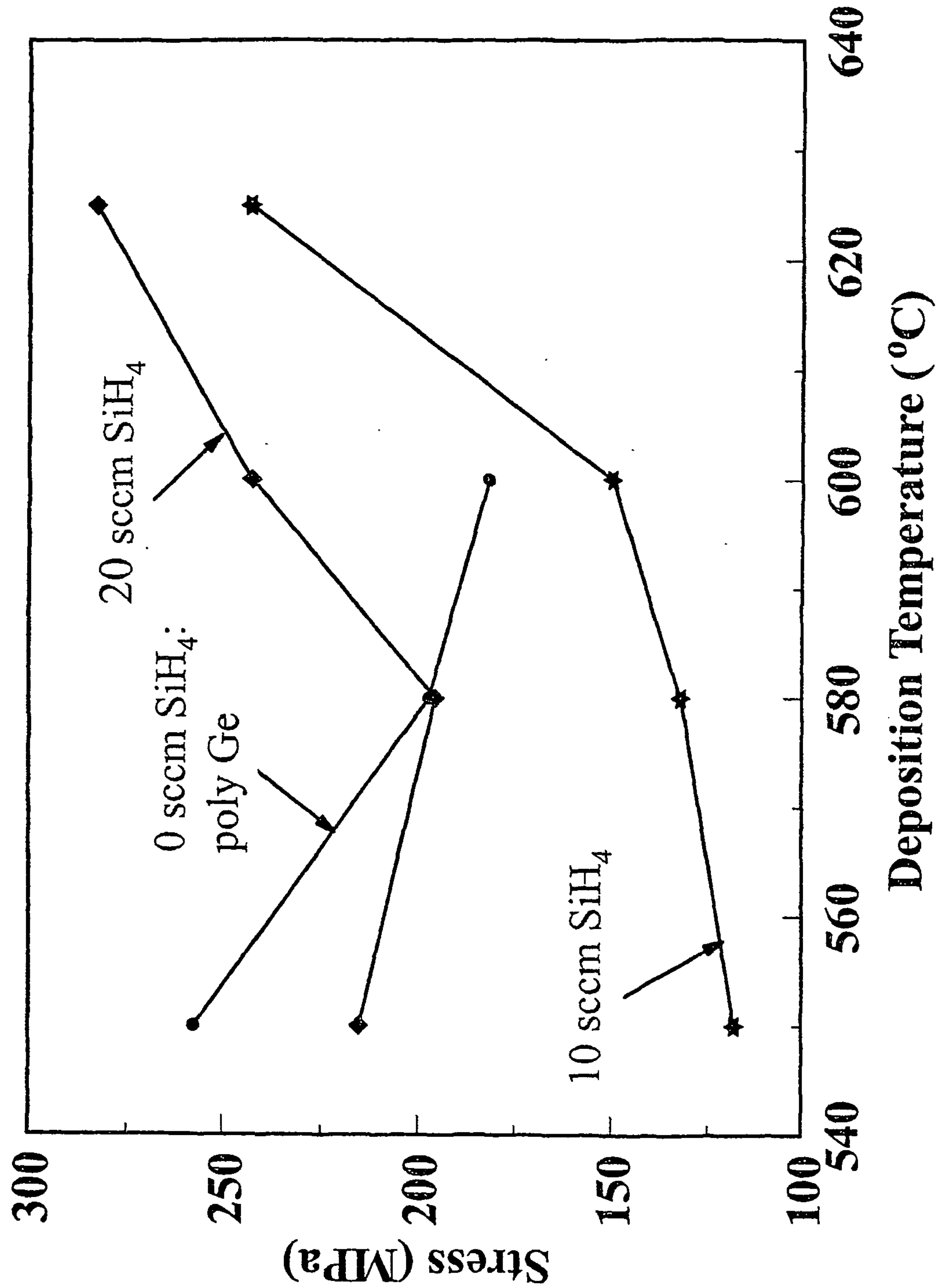
Stress (MPa)
300
250
200
150
100
540
560
580
600
620
640
Deposition Temperature (°C)
20 sccm $SiH_4$
0 sccm $SiH_4$:
poly Ge
10 sccm $SiH_4$

Figure 5

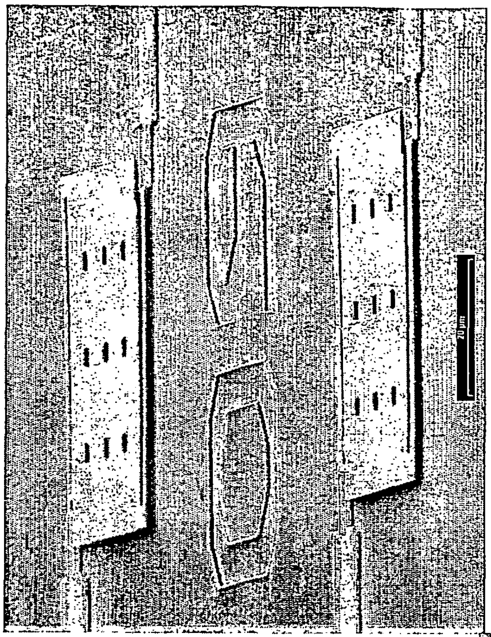

Figure 6b

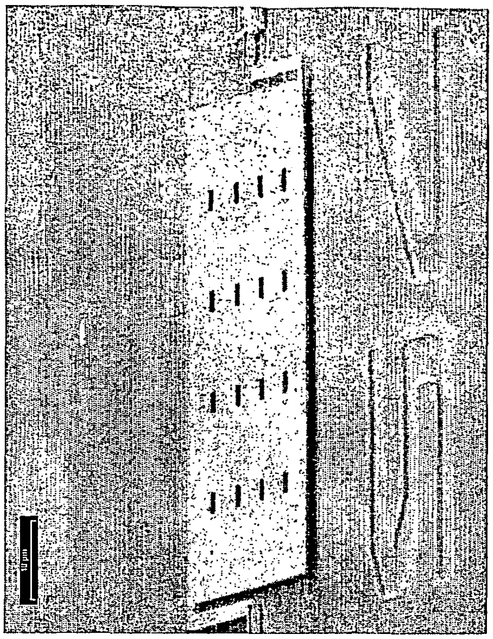

Figure 6c

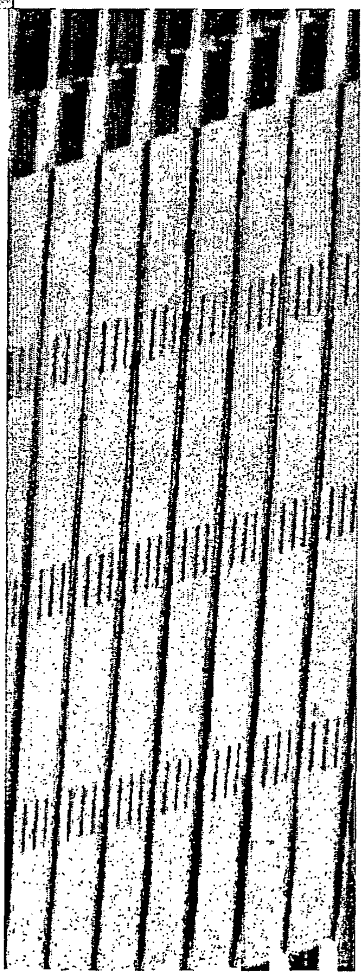

Figure 6a

Figure 7

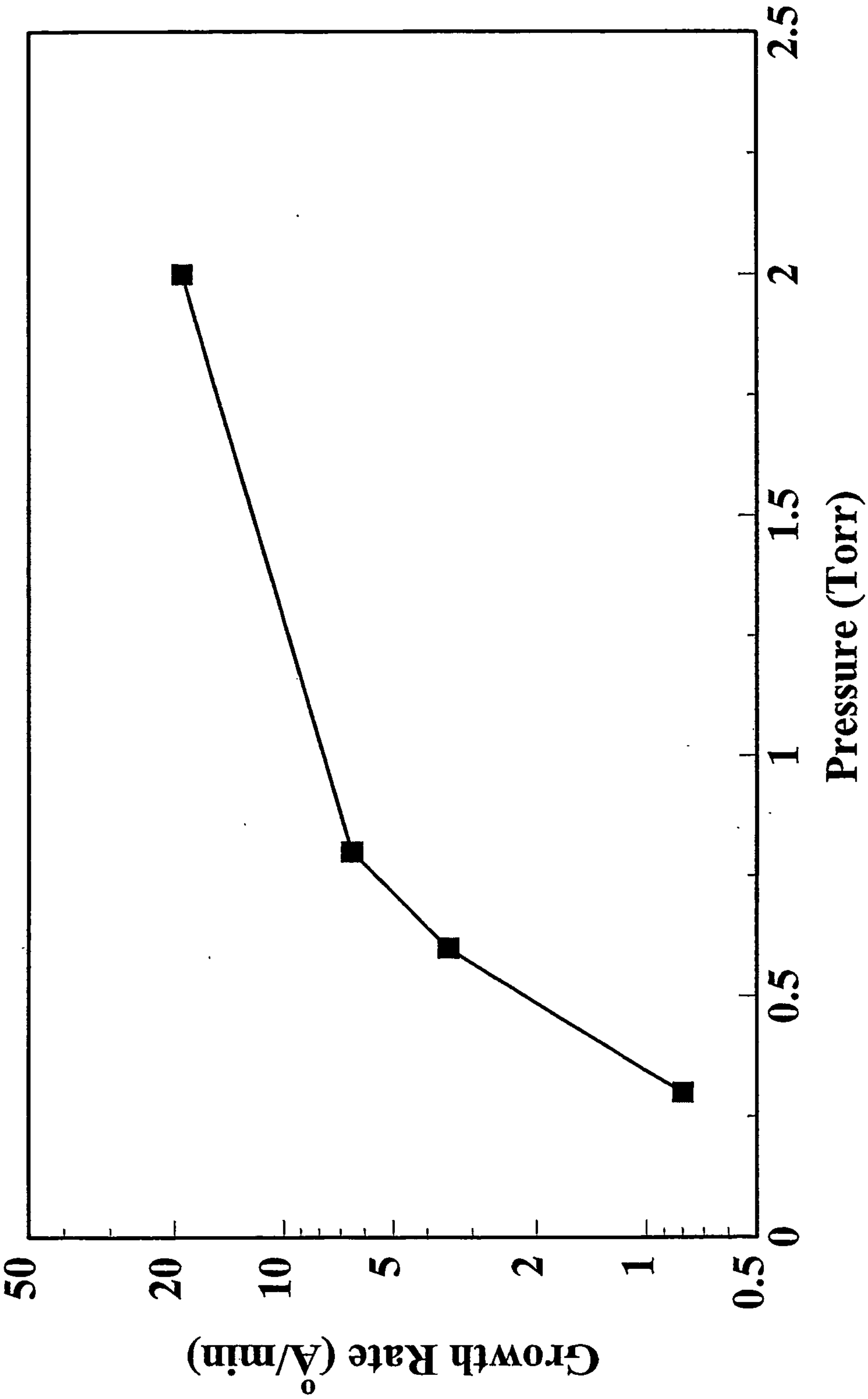

Figure 8

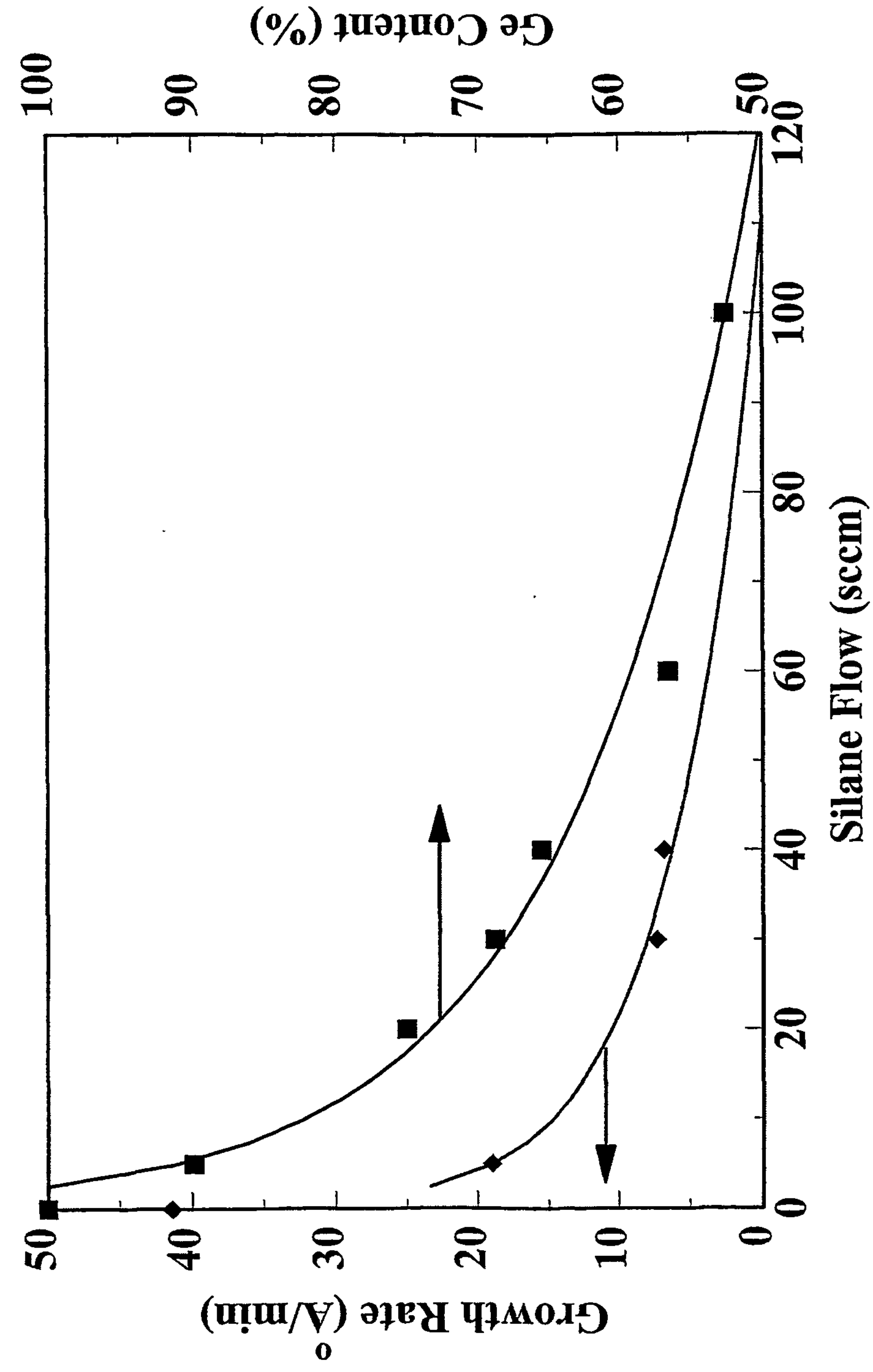
Ge Content (%)
100
90
80
70
60
50
Growth Rate (Å/min)
50
40
30
20
10
0
Silane Flow (sccm)
0
20
40
60
80
100
120

Figure 9

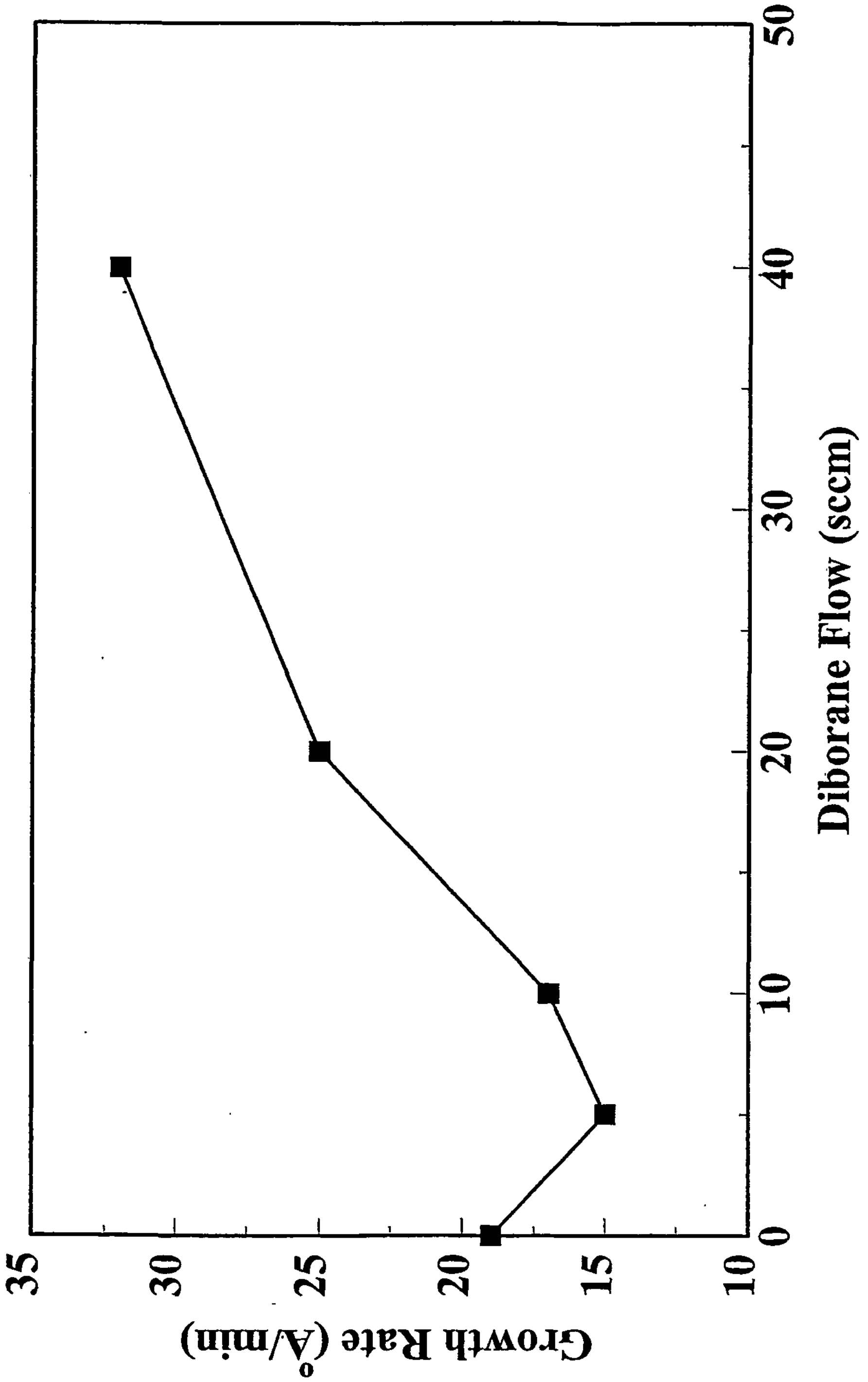
Growth Rate (Å/min)
35
30
25
20
15
10
0
10
20
30
40
50
Diborane Flow (sccm)

Figure 10

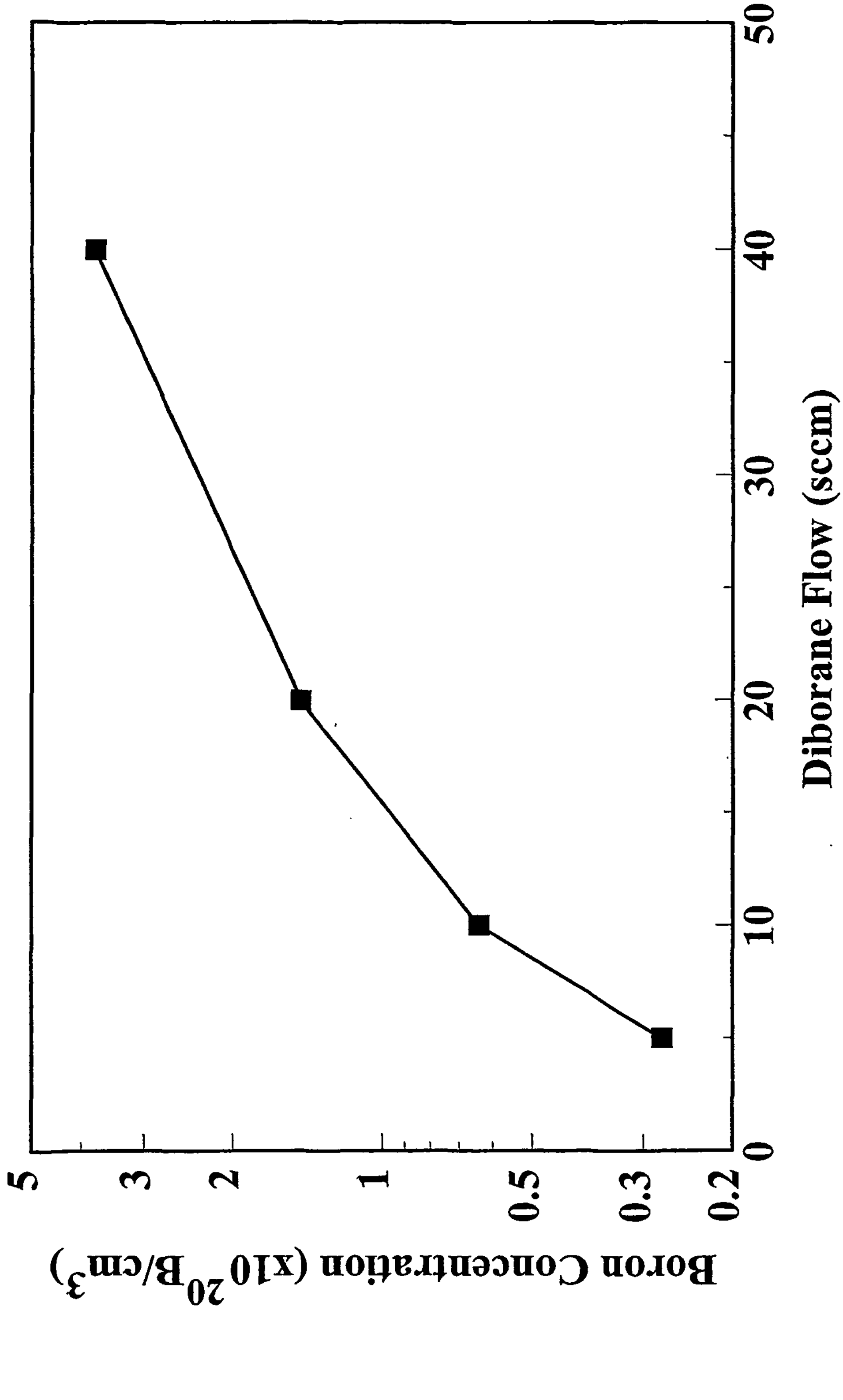
Boron Concentration (x10$^{20}$B/cm$^3$)
5
3
2
1
0.5
0.3
0.2
0
10
20
30
40
50
Diborane Flow (sccm)

Figure 11

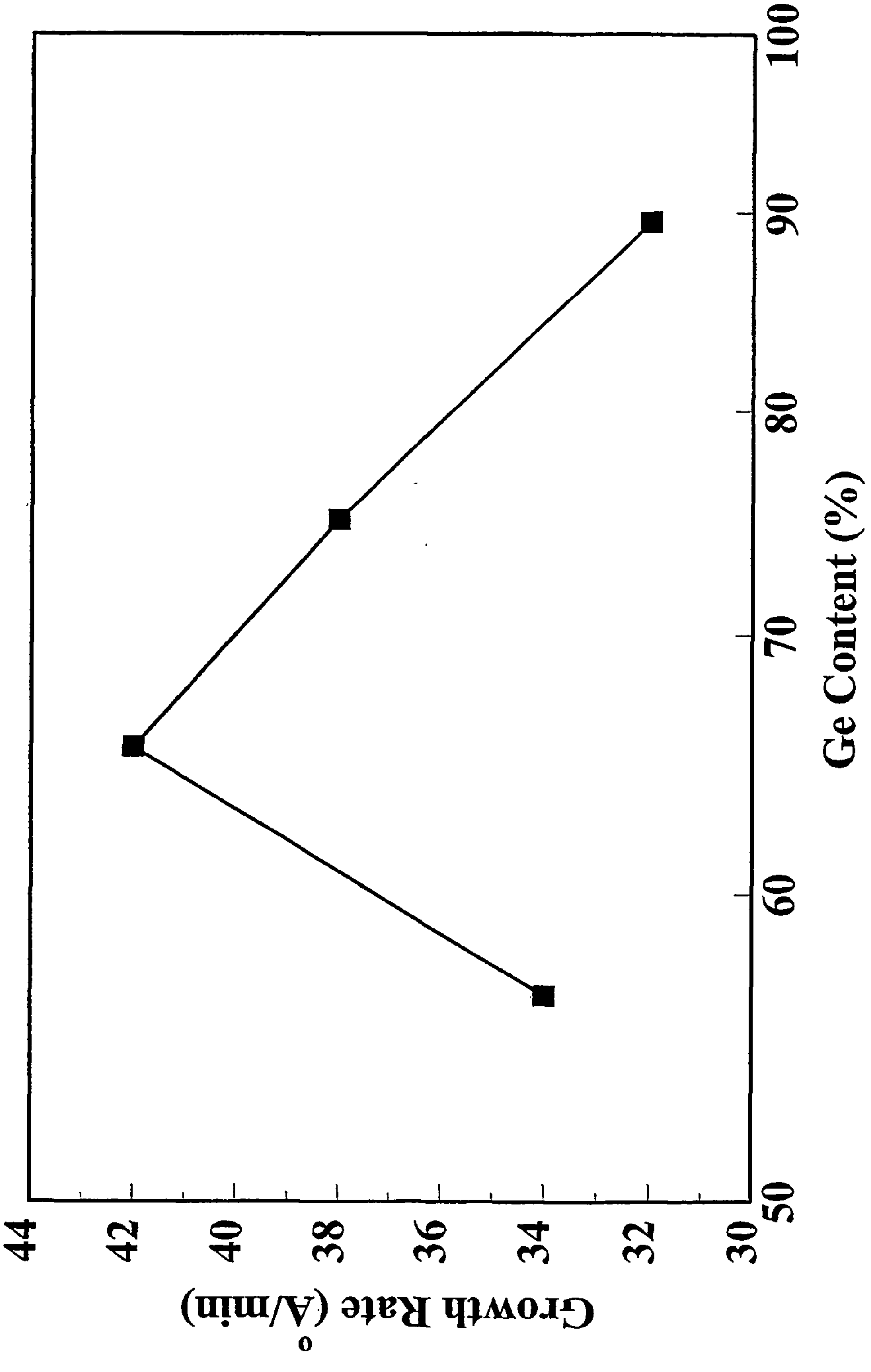
Growth Rate (Å/min)
44
42
40
38
36
34
32
30
Ge Content (%)
50
60
70
80
90
100

Figure 12

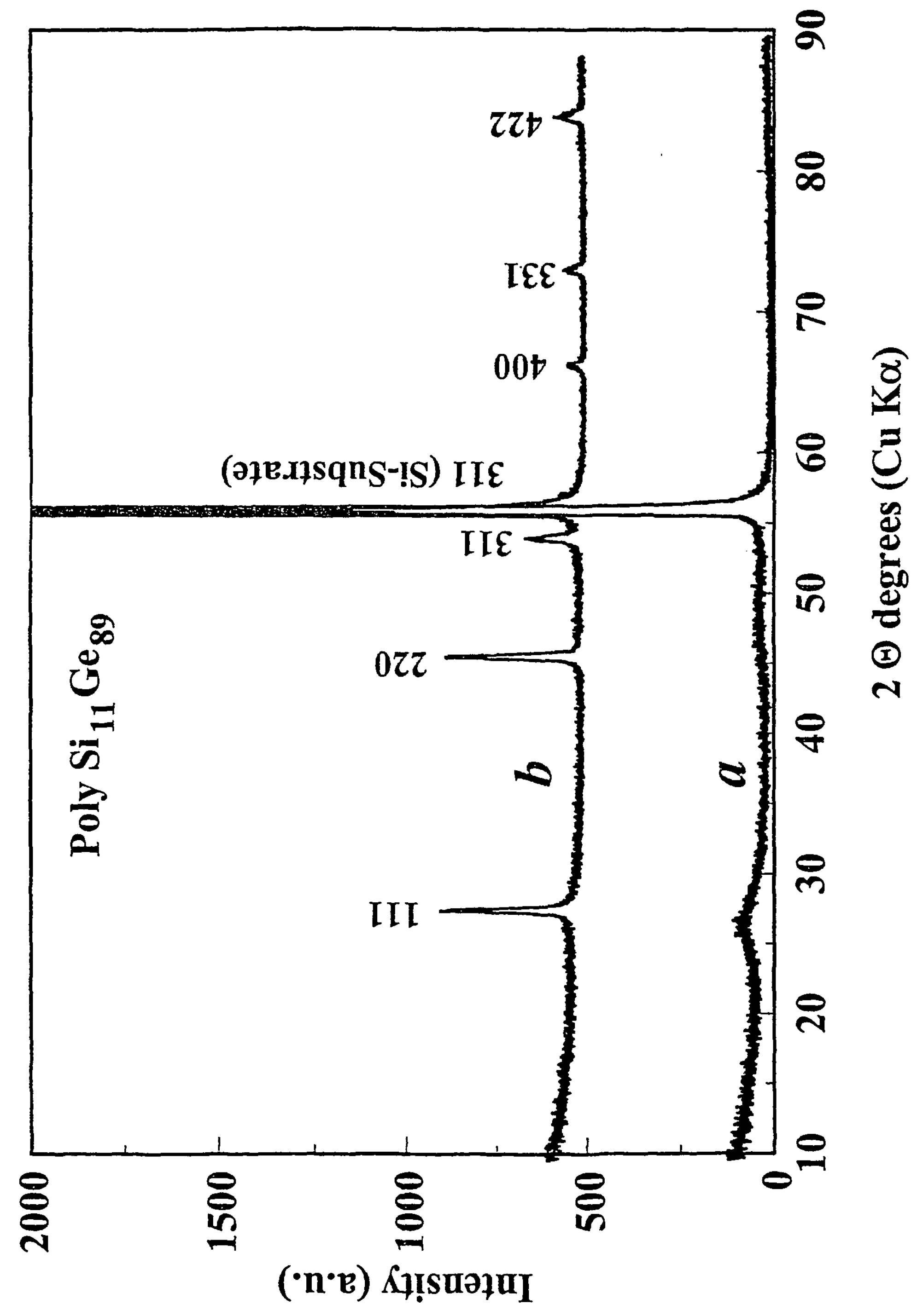
Poly $Si_{11}Ge_{89}$
111
220
311
311 (Si-Substrate)
400
331
422
b
a
Intensity (a.u.)
2000
1500
1000
500
0
10
20
30
40
50
60
70
80
90
2 Θ degrees (Cu Kα)

Figure 13

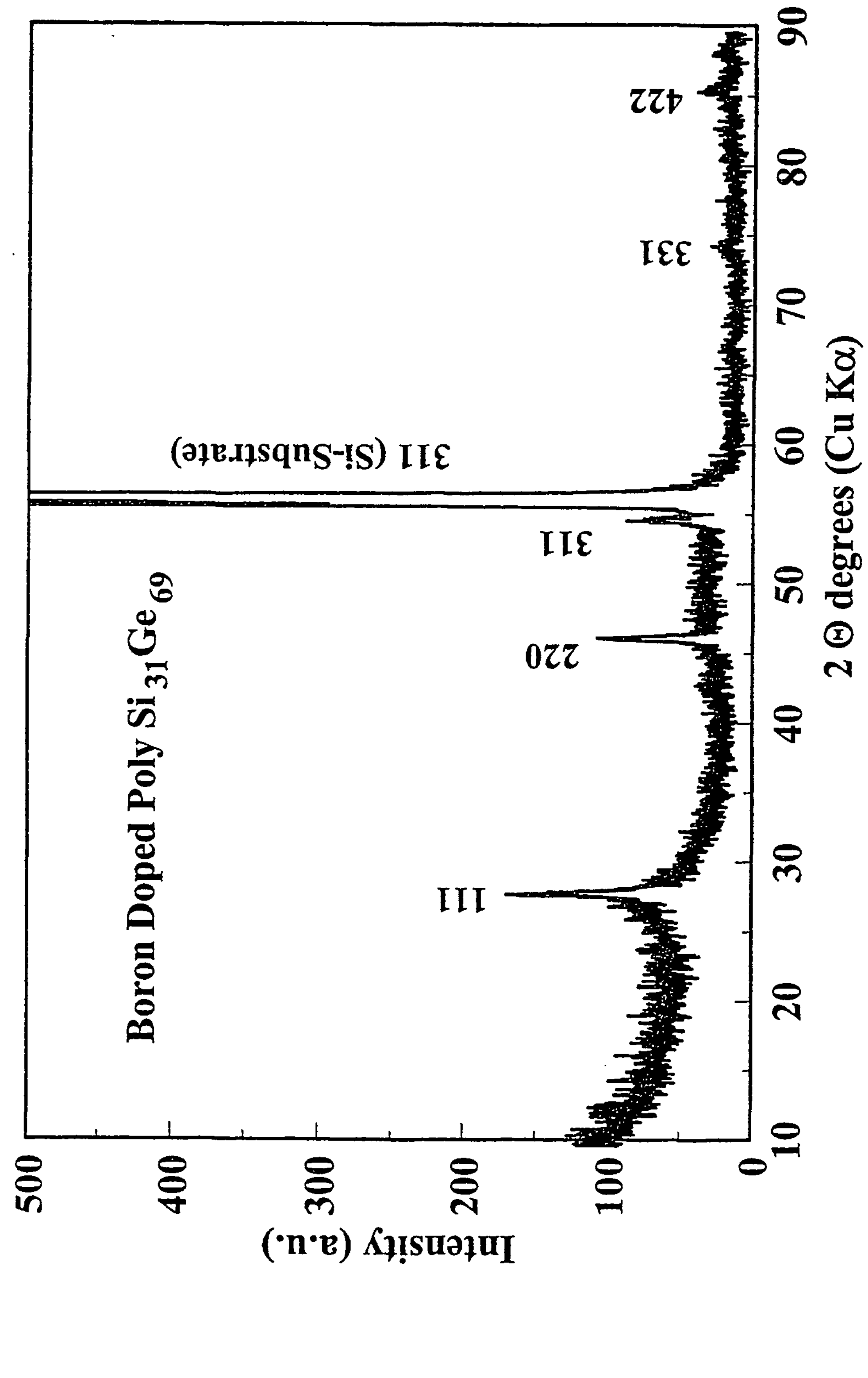
Boron Doped Poly $Si_{31}Ge_{69}$
111
220
311
311 (Si-Substrate)
331
422
Intensity (a.u.)
0
100
200
300
400
500
10
20
30
40
50
60
70
80
90
2 Θ degrees (Cu Kα)

Figure 14

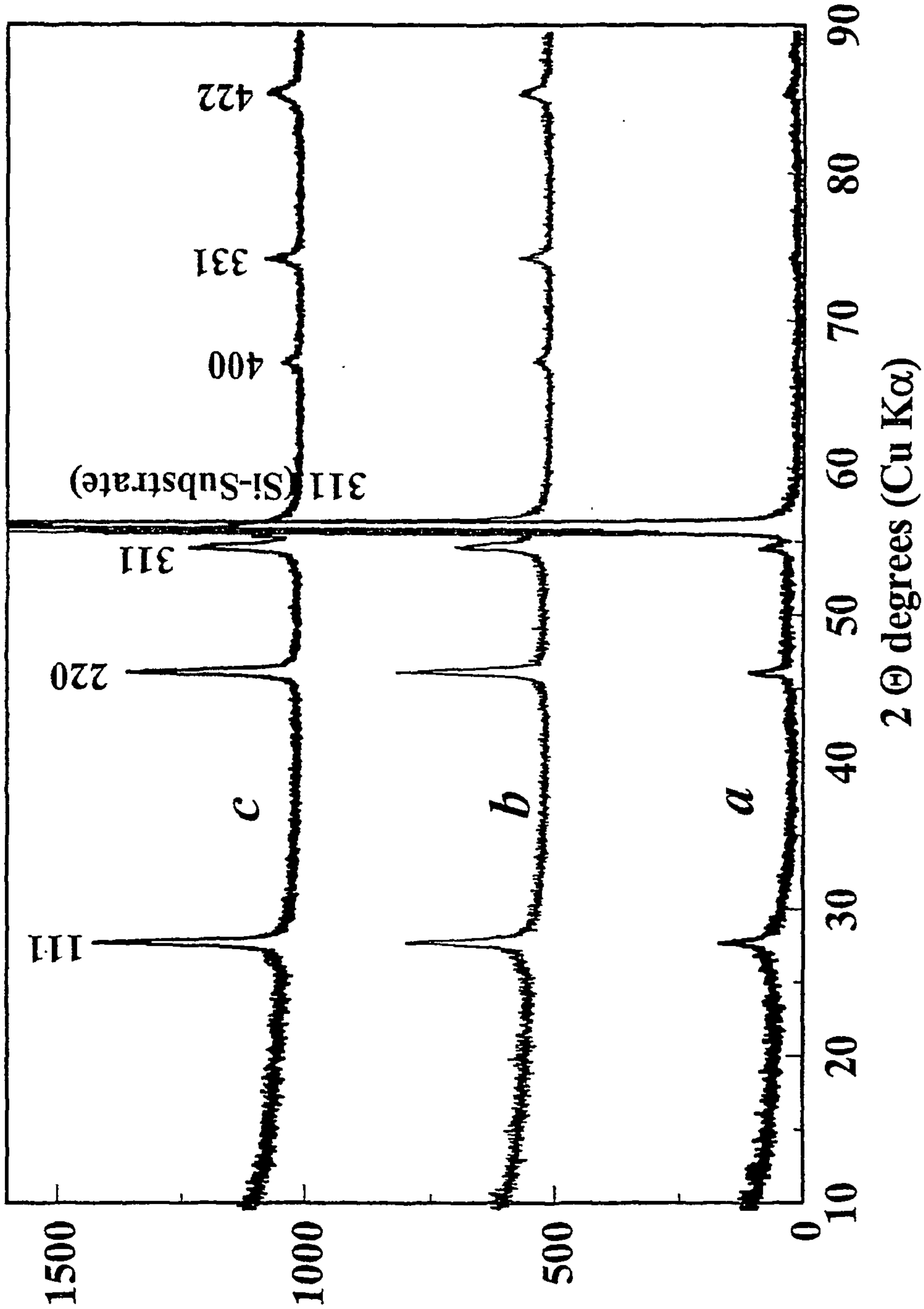


16/36

Figure 15

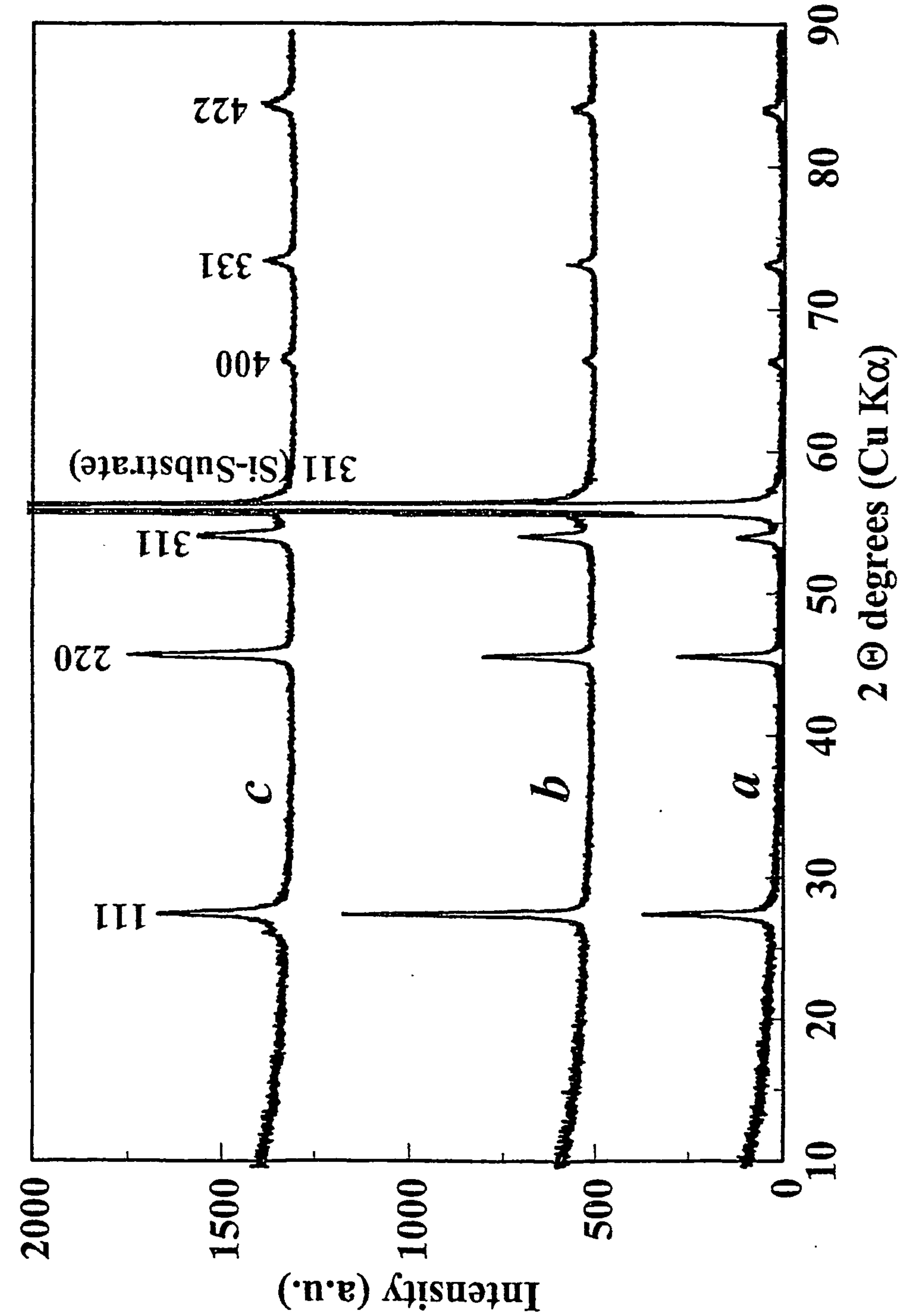
Intensity (a.u.)
2000
1500
1000
500
0
10
20
30
40
50
60
70
80
90
2 Θ degrees (Cu Kα)
111
220
311
311 (Si-Substrate)
400
331
422
a
b
c

Figure 16

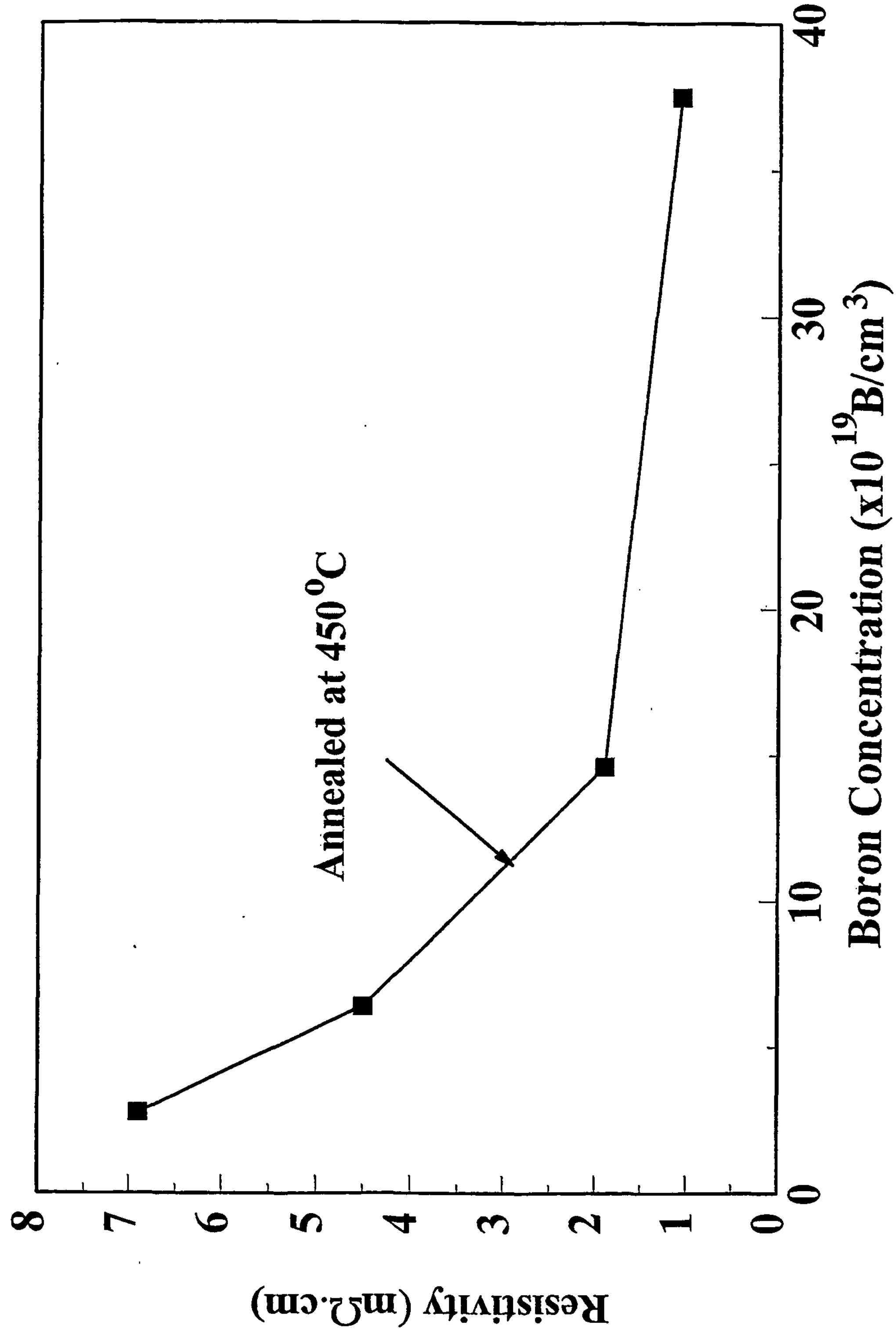
Annealed at 450 °C
Resistivity (mΩ.cm)
0
1
2
3
4
5
6
7
8
Boron Concentration (x10^19 B/cm^3)
0
10
20
30
40

Figure 17

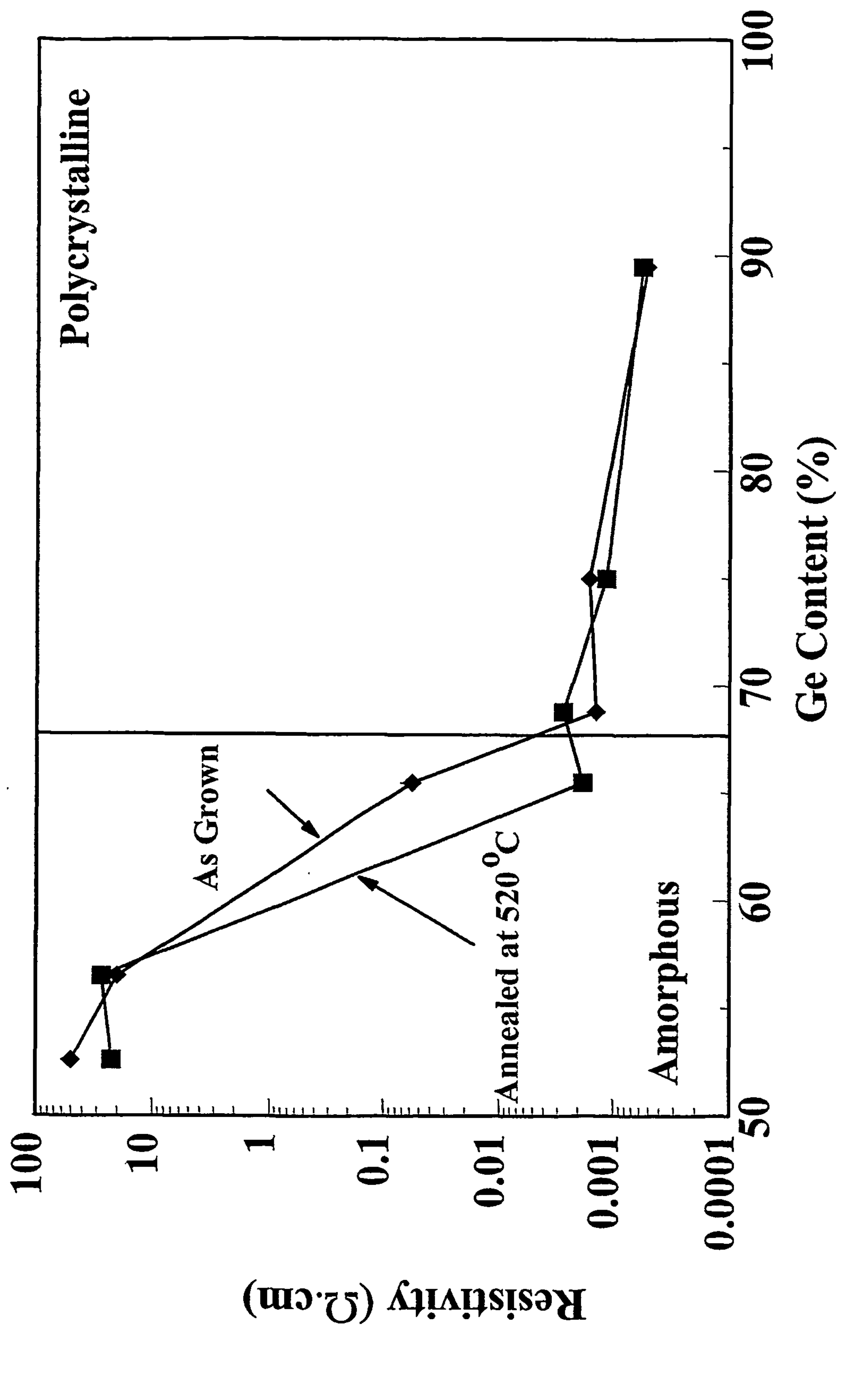

Polycrystalline
Amorphous
As Grown
Annealed at 520 °C
Resistivity (Ω.cm)
100
10
1
0.1
0.01
0.001
0.0001
Ge Content (%)
50
60
70
80
90
100

Figure 18

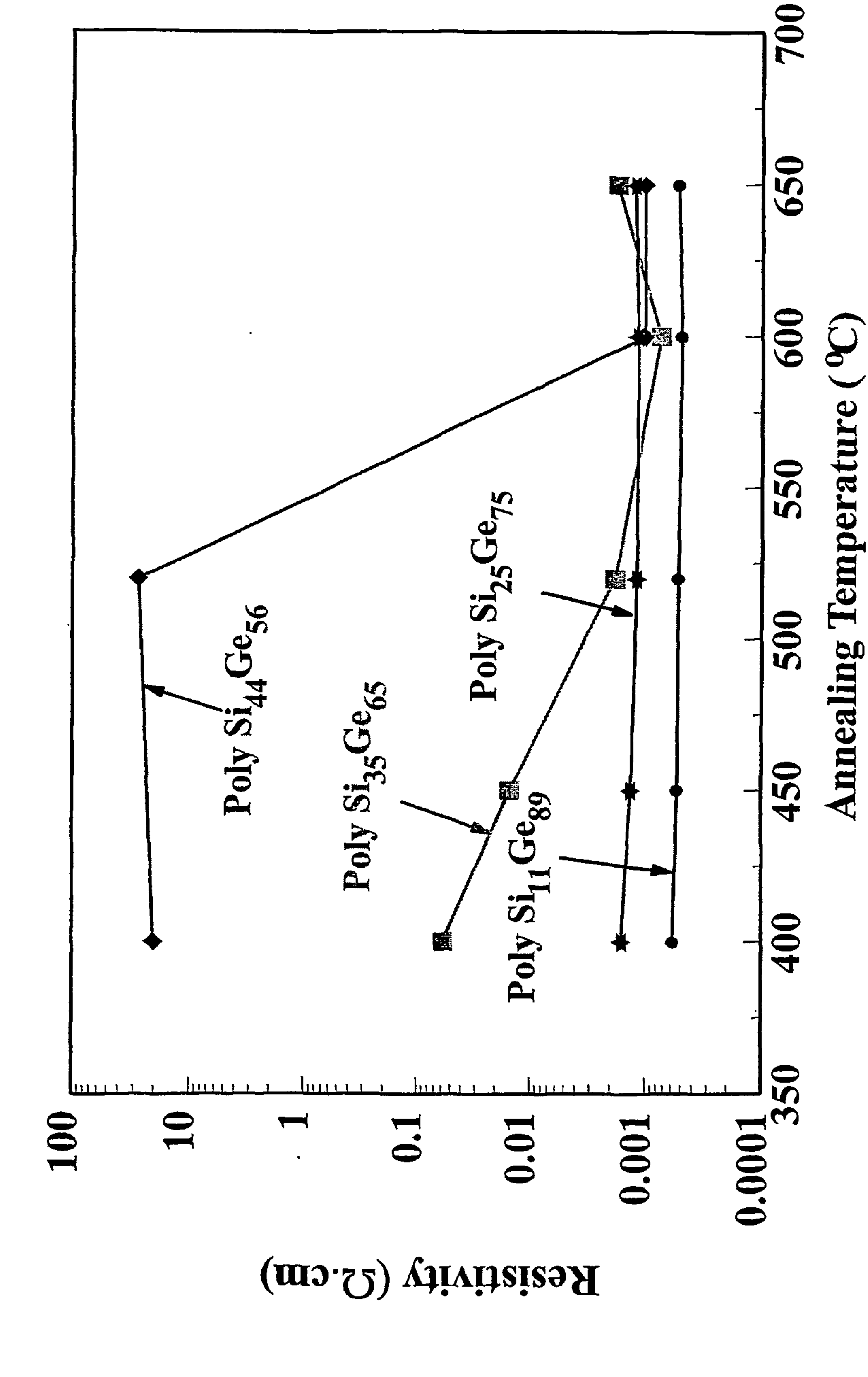
Poly $Si_{44}Ge_{56}$
Poly $Si_{35}Ge_{65}$
Poly $Si_{25}Ge_{75}$
Poly $Si_{11}Ge_{89}$
Resistivity (Ω.cm)
100
10
1
0.1
0.01
0.001
0.0001
350
400
450
500
550
600
650
700
Annealing Temperature ( °C)

Figure 19

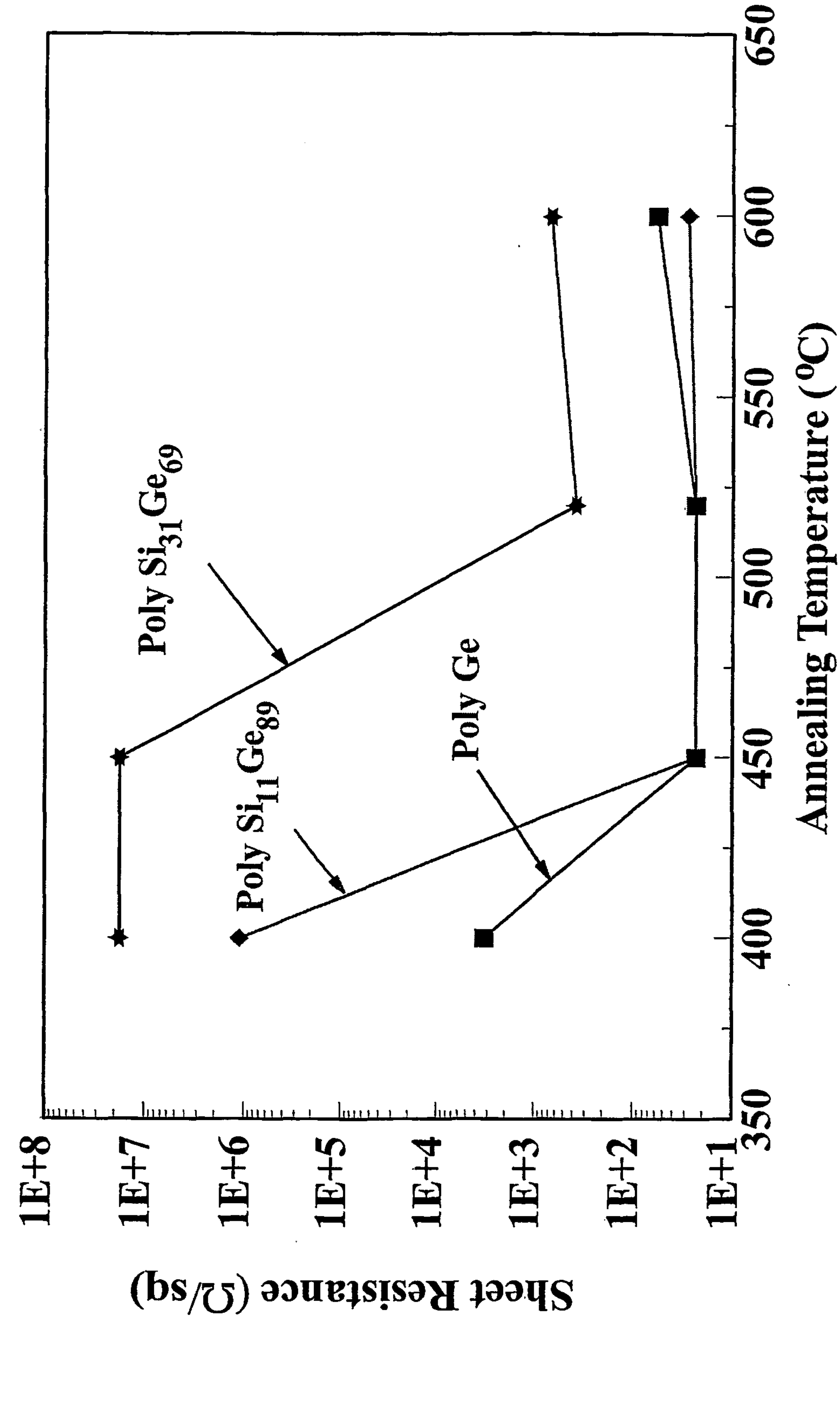

Poly $Si_{31}Ge_{69}$
Poly $Si_{11}Ge_{89}$
Poly Ge
Sheet Resistance (Ω/sq)
1E+8
1E+7
1E+6
1E+5
1E+4
1E+3
1E+2
1E+1
350
400
450
500
550
600
650
Annealing Temperature (°C)

Figure 20

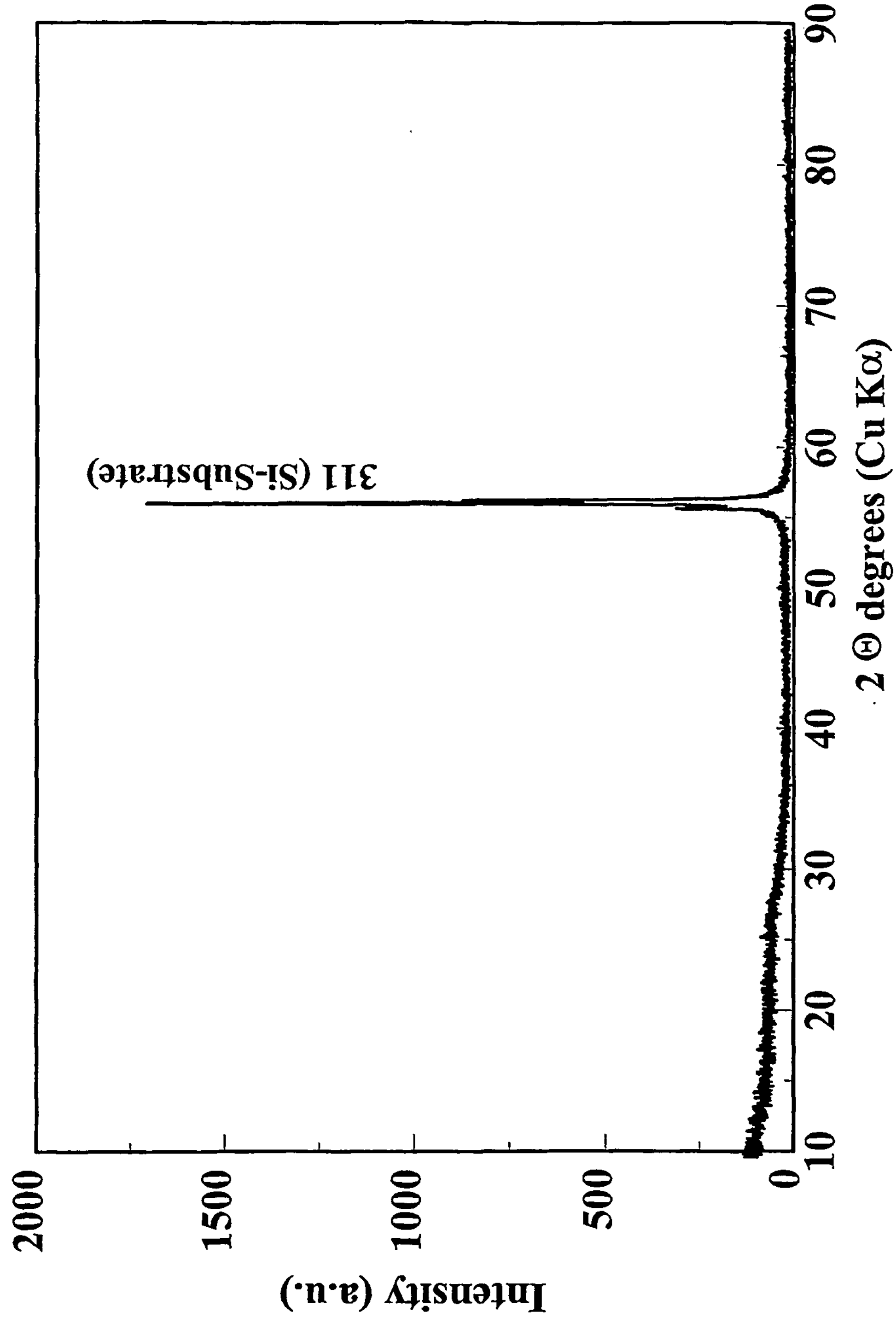

311 (Si-Substrate)
Intensity (a.u.)
2000
1500
1000
500
0
10
20
30
40
50
60
70
80
90
2 Θ degrees (Cu Kα)

Figure 21

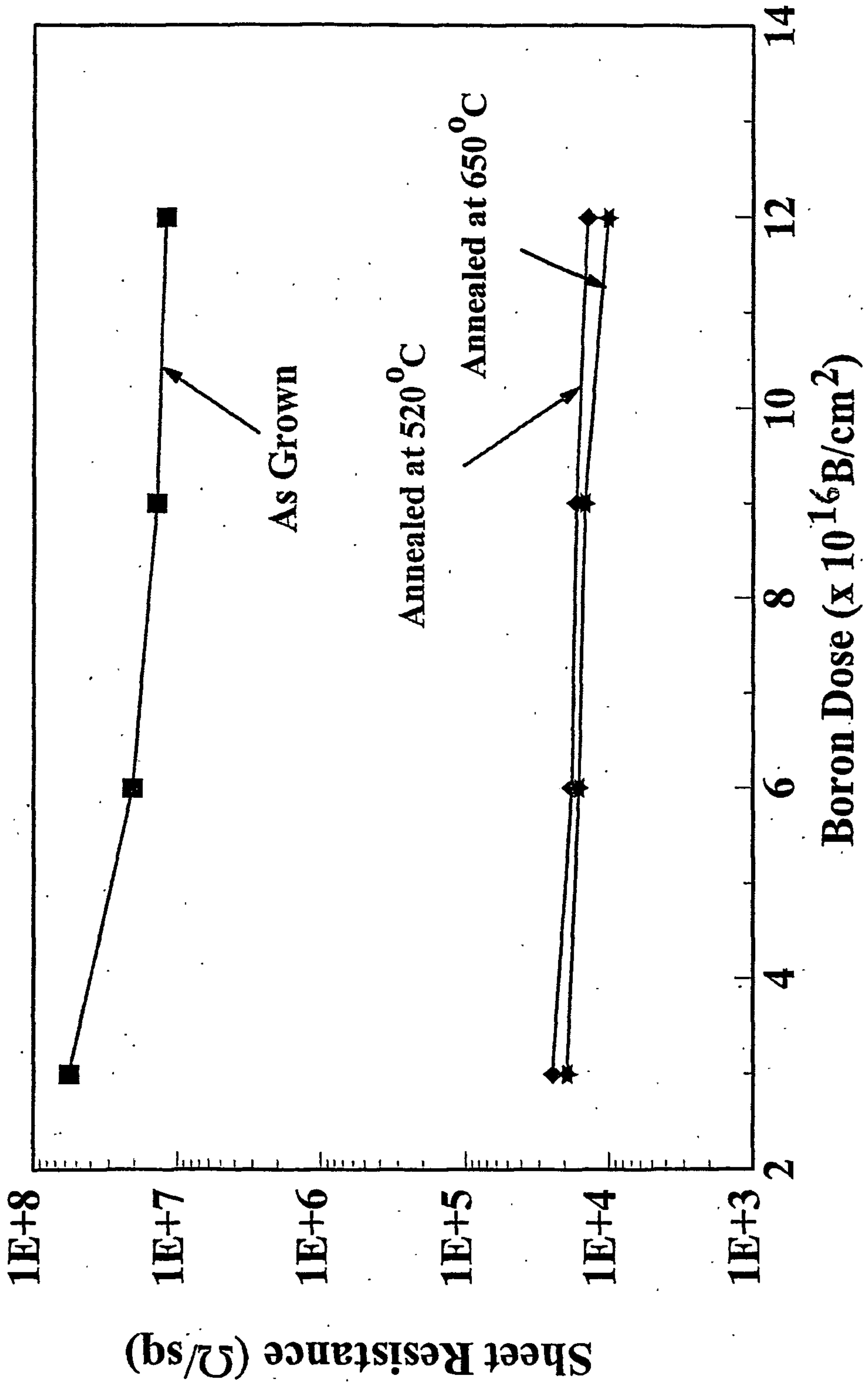
As Grown
Annealed at 520$^0$C
Annealed at 650$^0$C
Sheet Resistance ($\Omega$/sq)
1E+8
1E+7
1E+6
1E+5
1E+4
1E+3
2
4
6
8
10
12
14
Boron Dose (x 10$^{16}$B/cm$^2$)

Figure 22

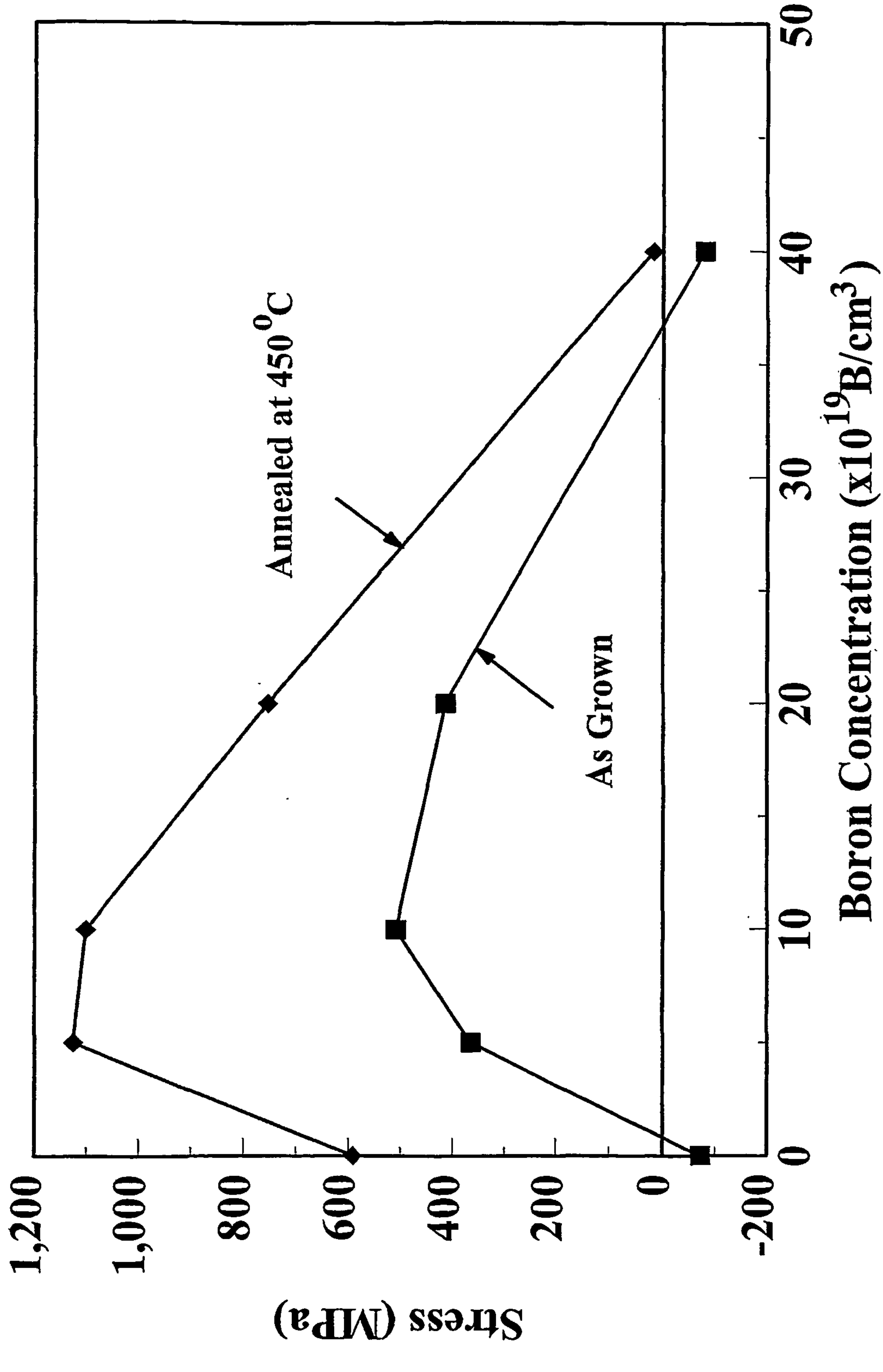
Annealed at 450$^0$C
As Grown
Stress (MPa)
1,200
1,000
800
600
400
200
0
-200
Boron Concentration (x10$^{19}$B/cm$^3$)
0
10
20
30
40
50

Figure 23

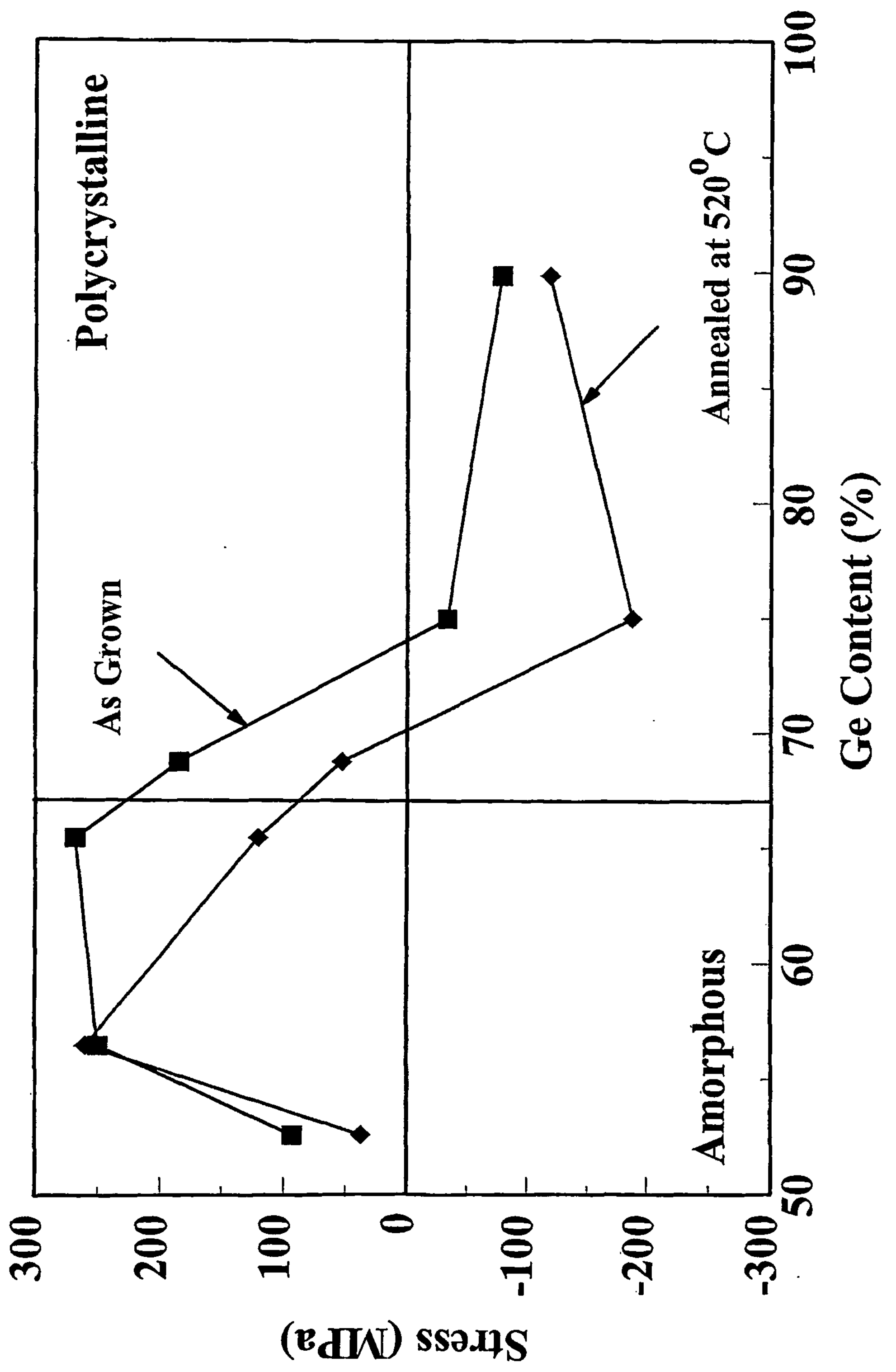
Polycrystalline
As Grown
Annealed at 520°C
Amorphous
300
200
100
0
-100
-200
-300
Stress (MPa)
50
60
70
80
90
100
Ge Content (%)

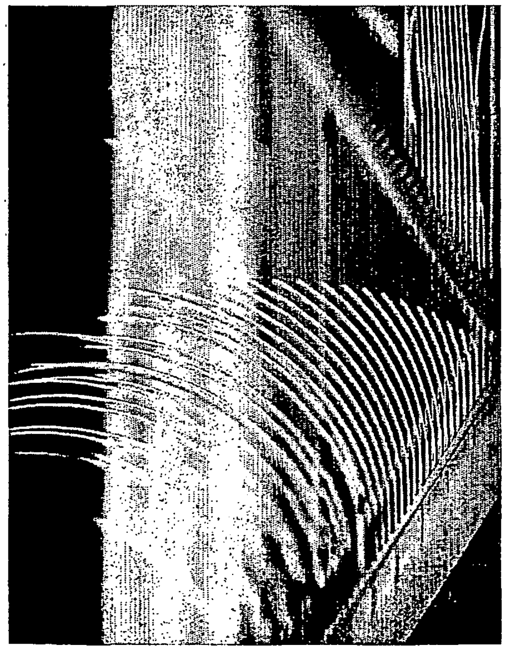

Figure 24a

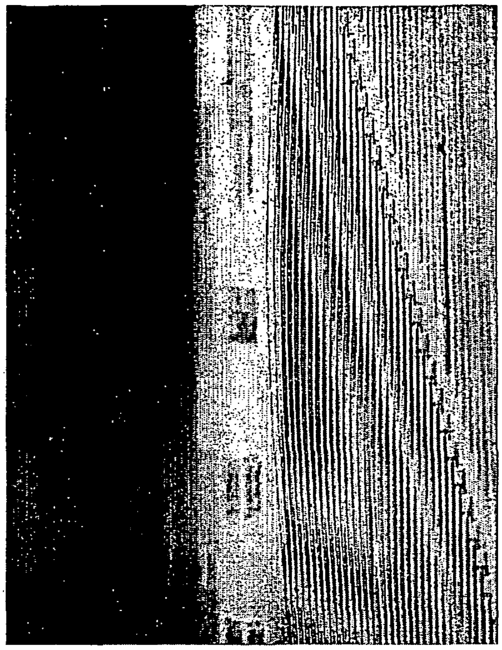

Figure 24b

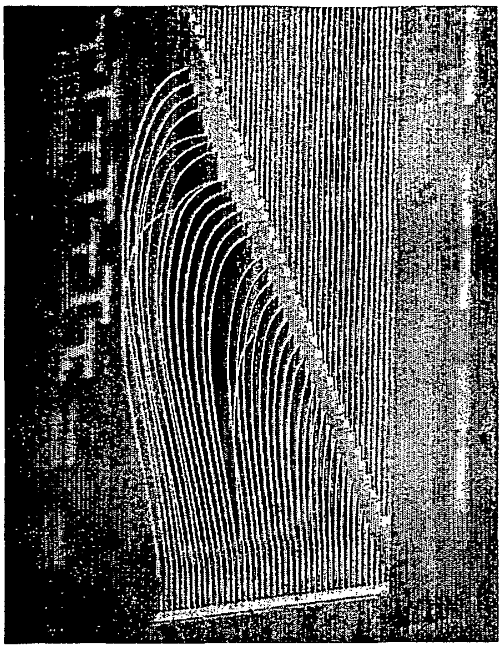

Figure 24c

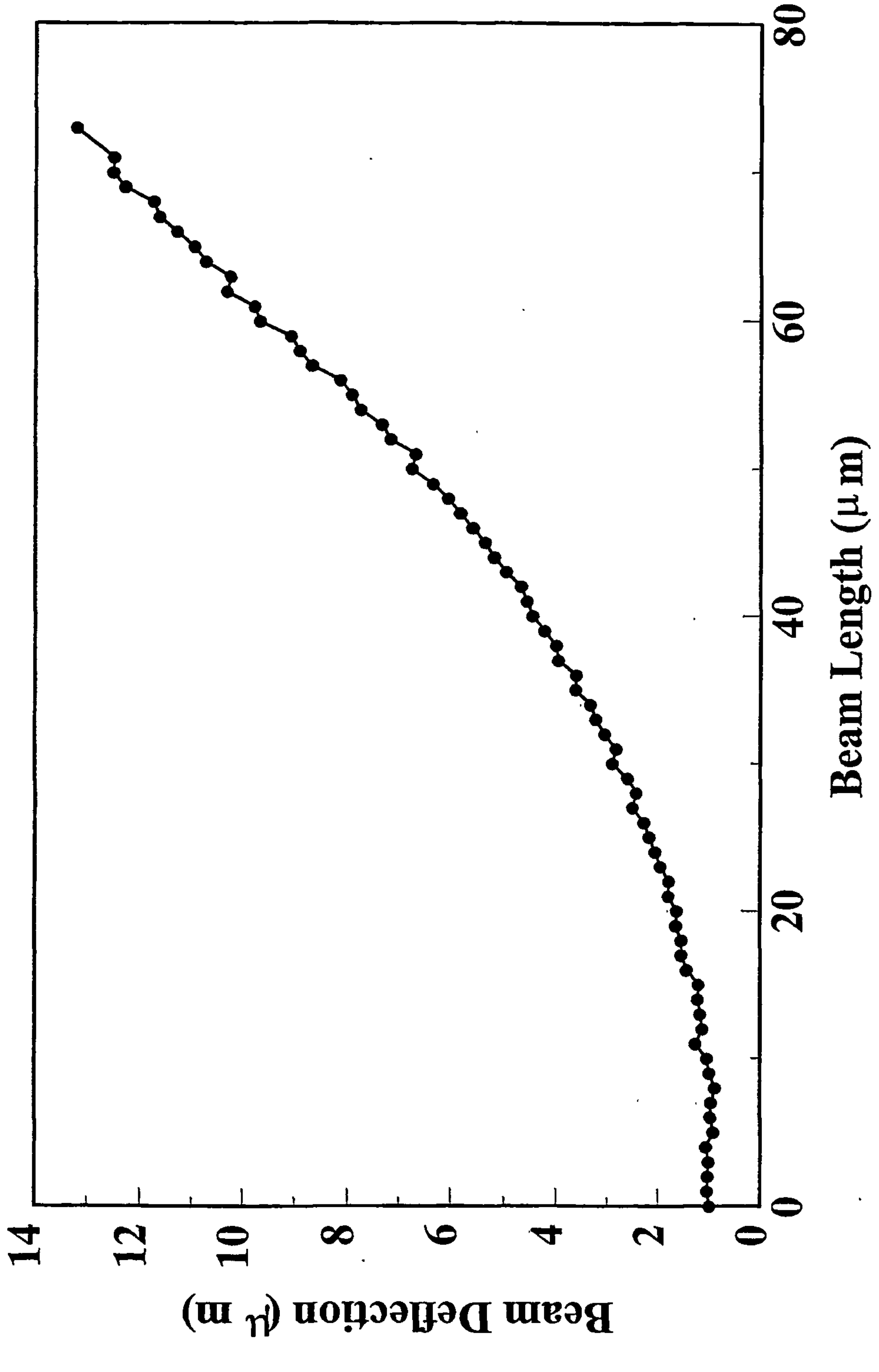


Figure 25a

Figure 25b

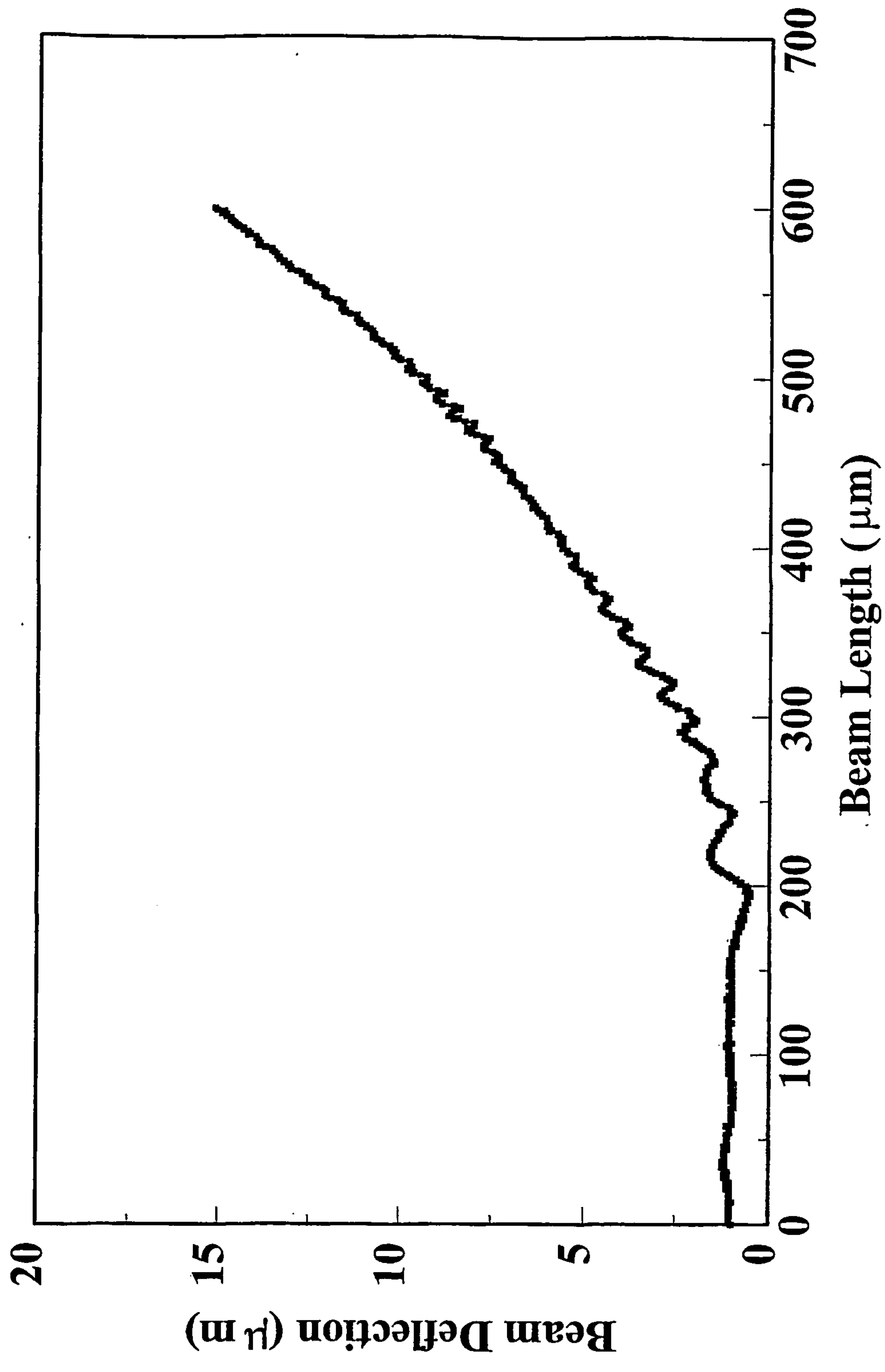
Beam Deflection (μ m)
20
15
10
5
0
0
100
200
300
400
500
600
700
Beam Length (μm)

Figure 25c

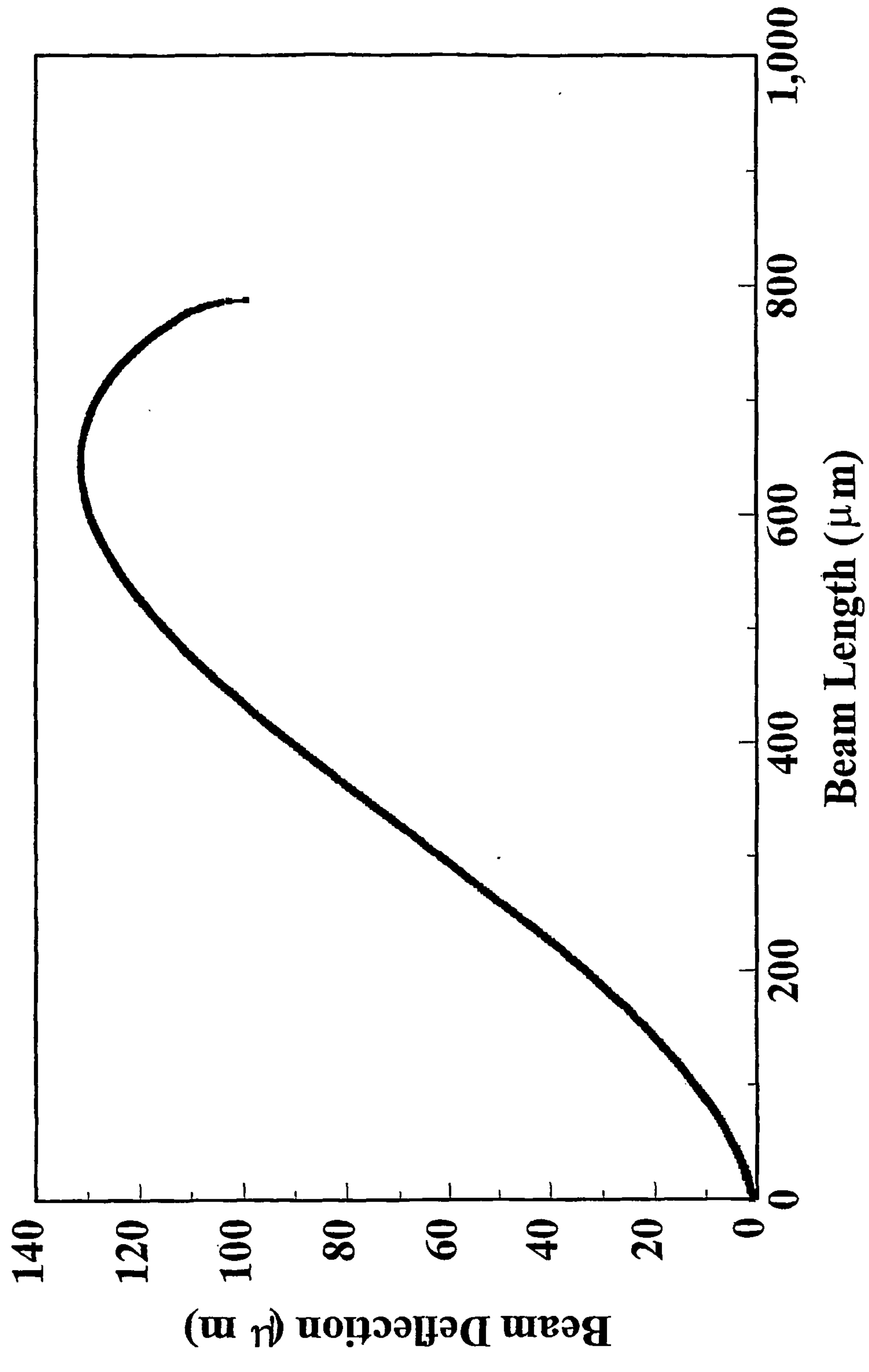
Beam Deflection (μ m)
140
120
100
80
60
40
20
0
0
200
400
600
800
1,000
Beam Length (μ m)

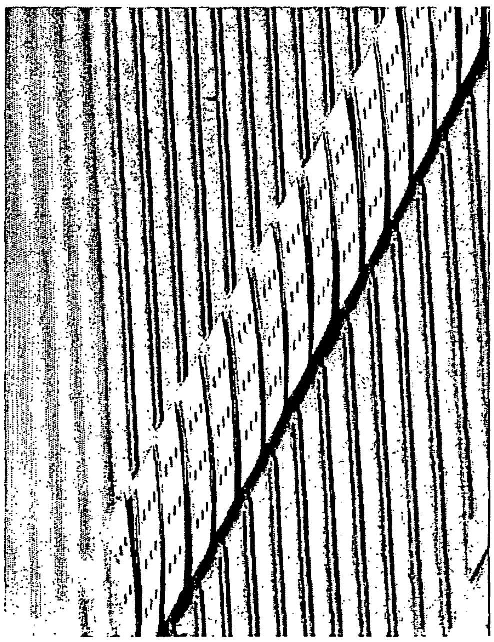

Figure 26a

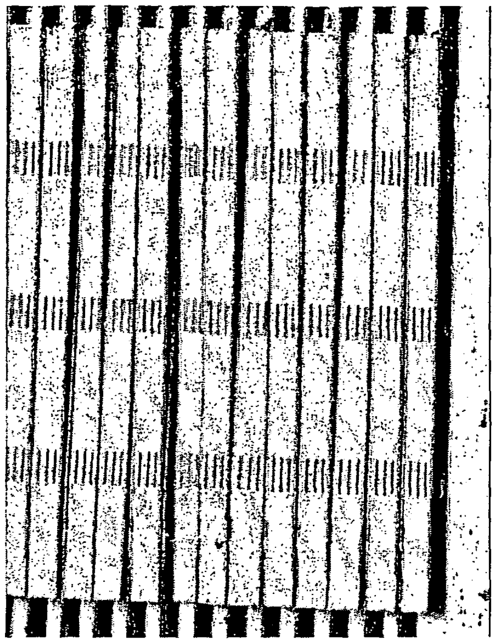

Figure 26b

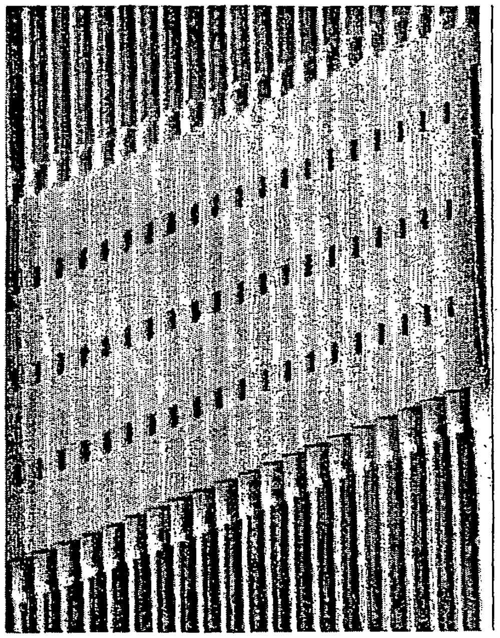

Figure 26c

Fig. 27

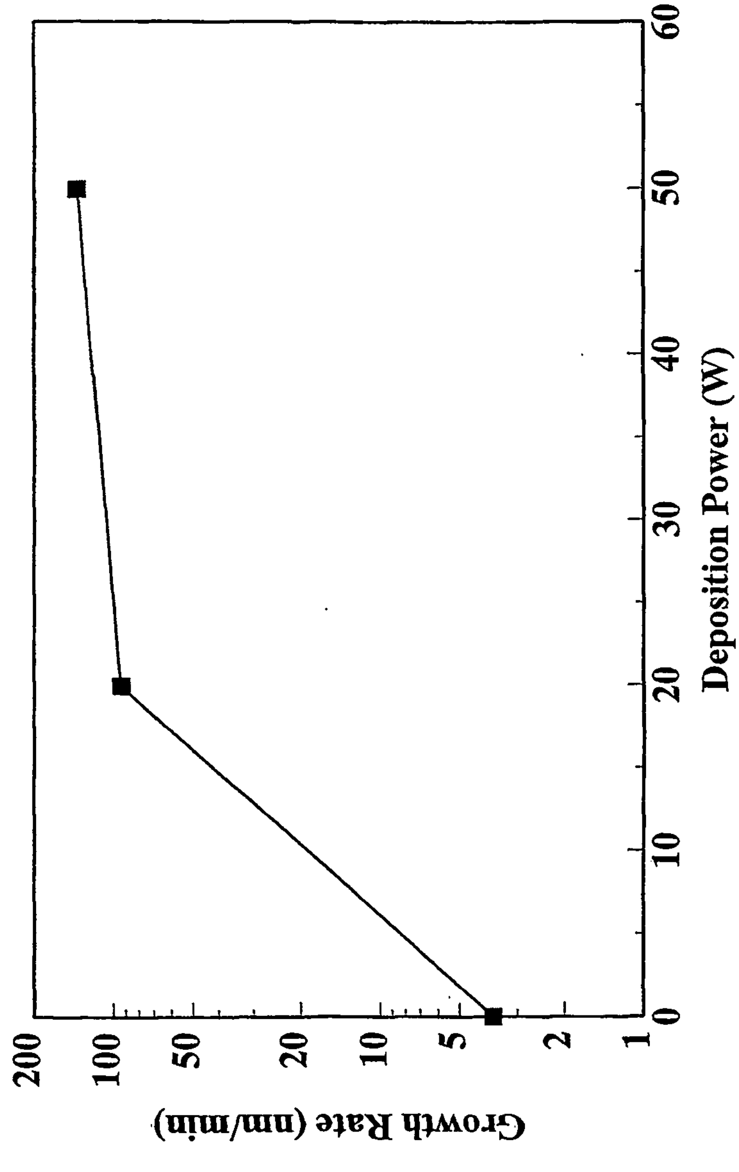
Growth Rate (nm/min)
200
100
50
20
10
5
2
1
0
10
20
30
40
50
60
Deposition Power (W)

Fig. 28

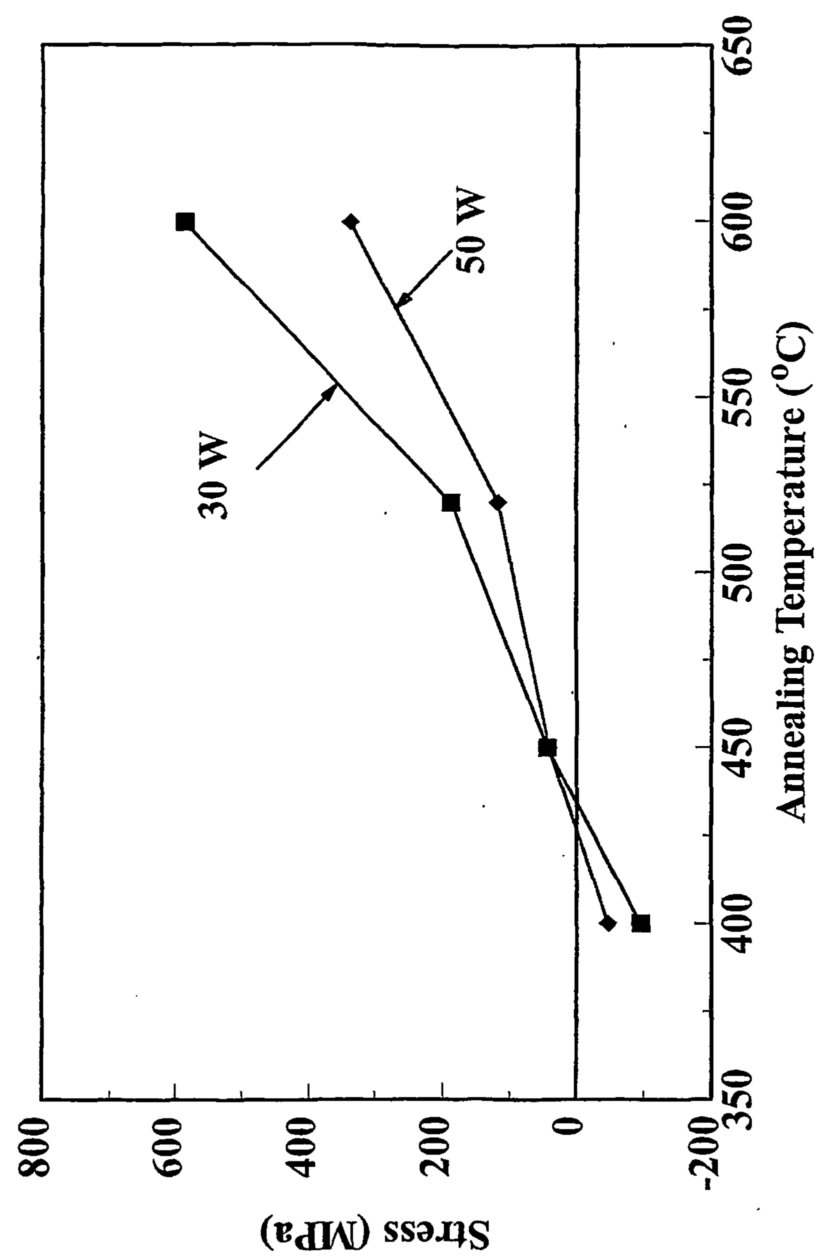
Stress (MPa)
800
600
400
200
0
-200
350
400
450
500
550
600
650
Annealing Temperature (°C)
30 W
50 W

Fig. 29

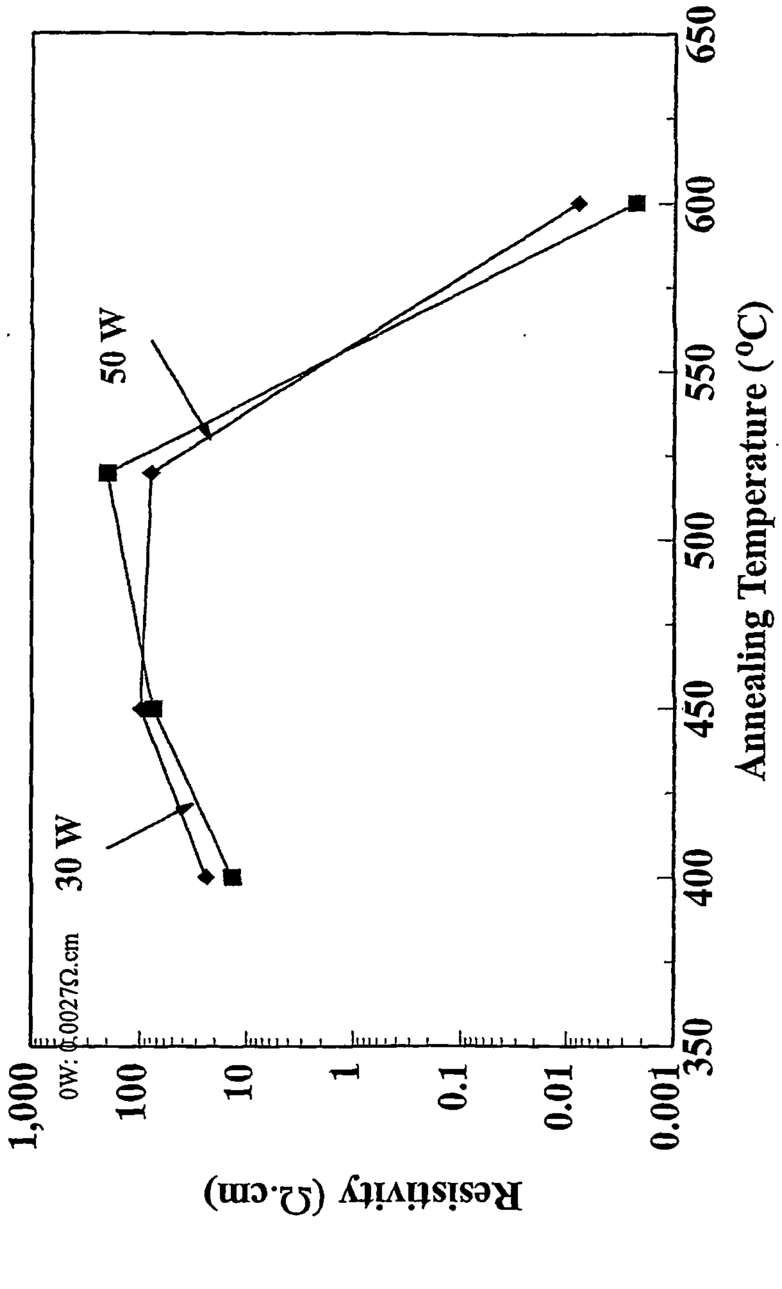
Resistivity (Ω.cm)
Annealing Temperature (°C)
30 W
50 W
0W: 0.0027Ω.cm
1,000
100
10
1
0.1
0.01
0.001
350
400
450
500
550
600
650

Fig. 30

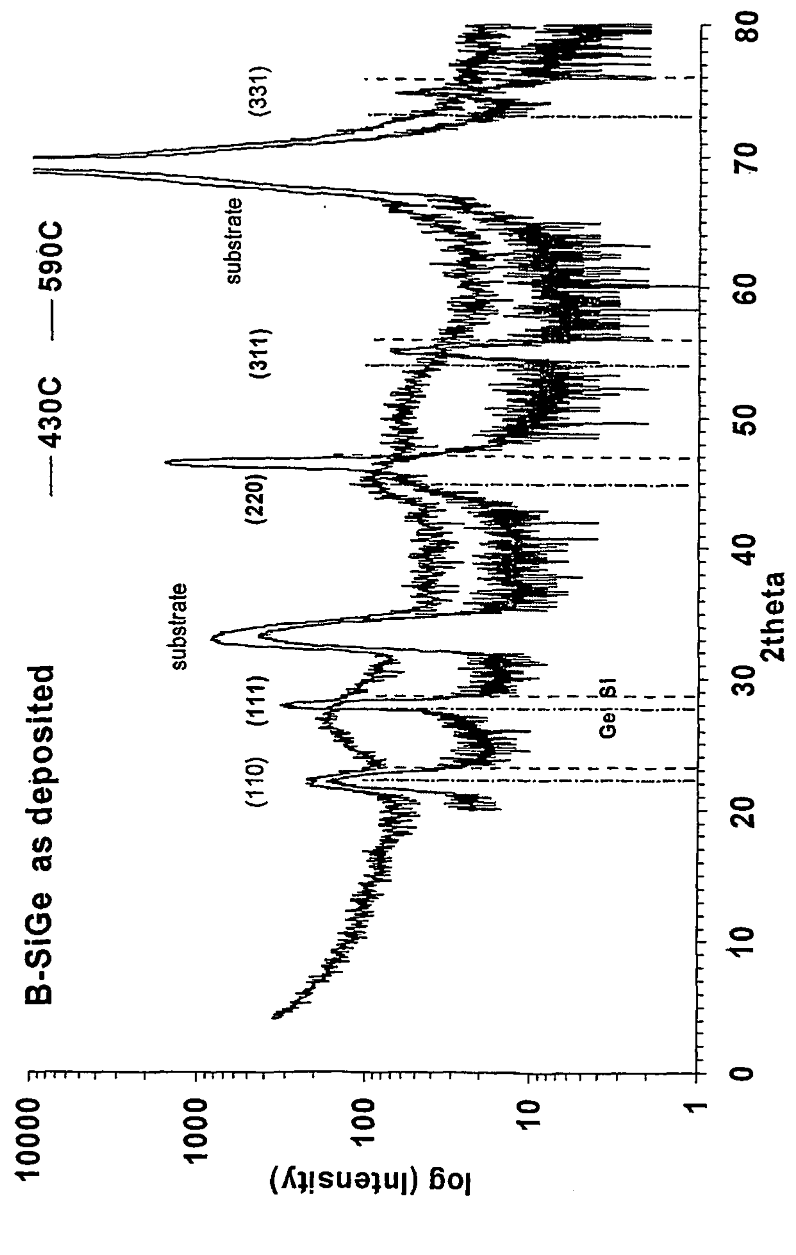
B-SiGe as deposited
430C
590C
substrate
(110)
(111)
(220)
(311)
substrate
(331)
Ge
Si
log (Intensity)
10000
1000
100
10
1
2theta
0
10
20
30
40
50
60
70
80

Fig. 31

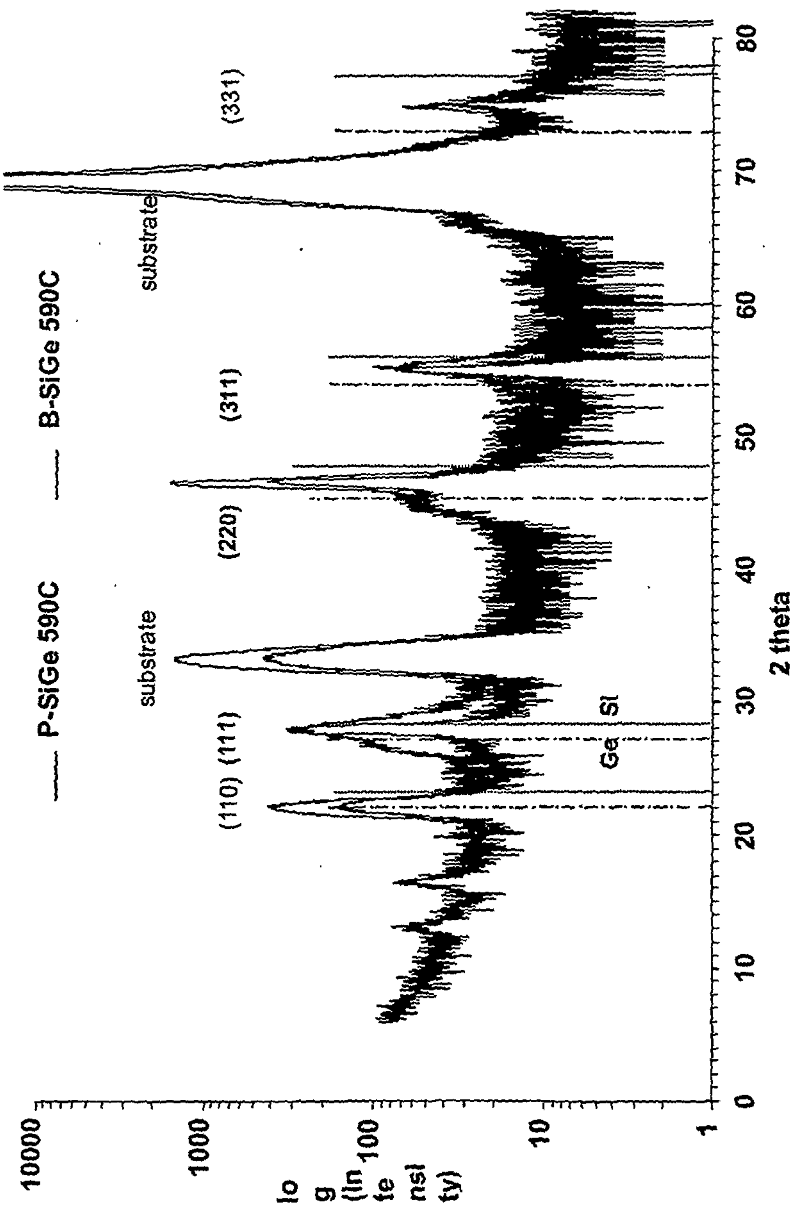
P-SiGe 590C
B-SiGe 590C
substrate
substrate
(110) (111)
(220)
(311)
(331)
Ge Si
log (Intensity)
10000
1000
100
10
1
0
10
20
30
40
50
60
70
80
2 theta

Fig. 32

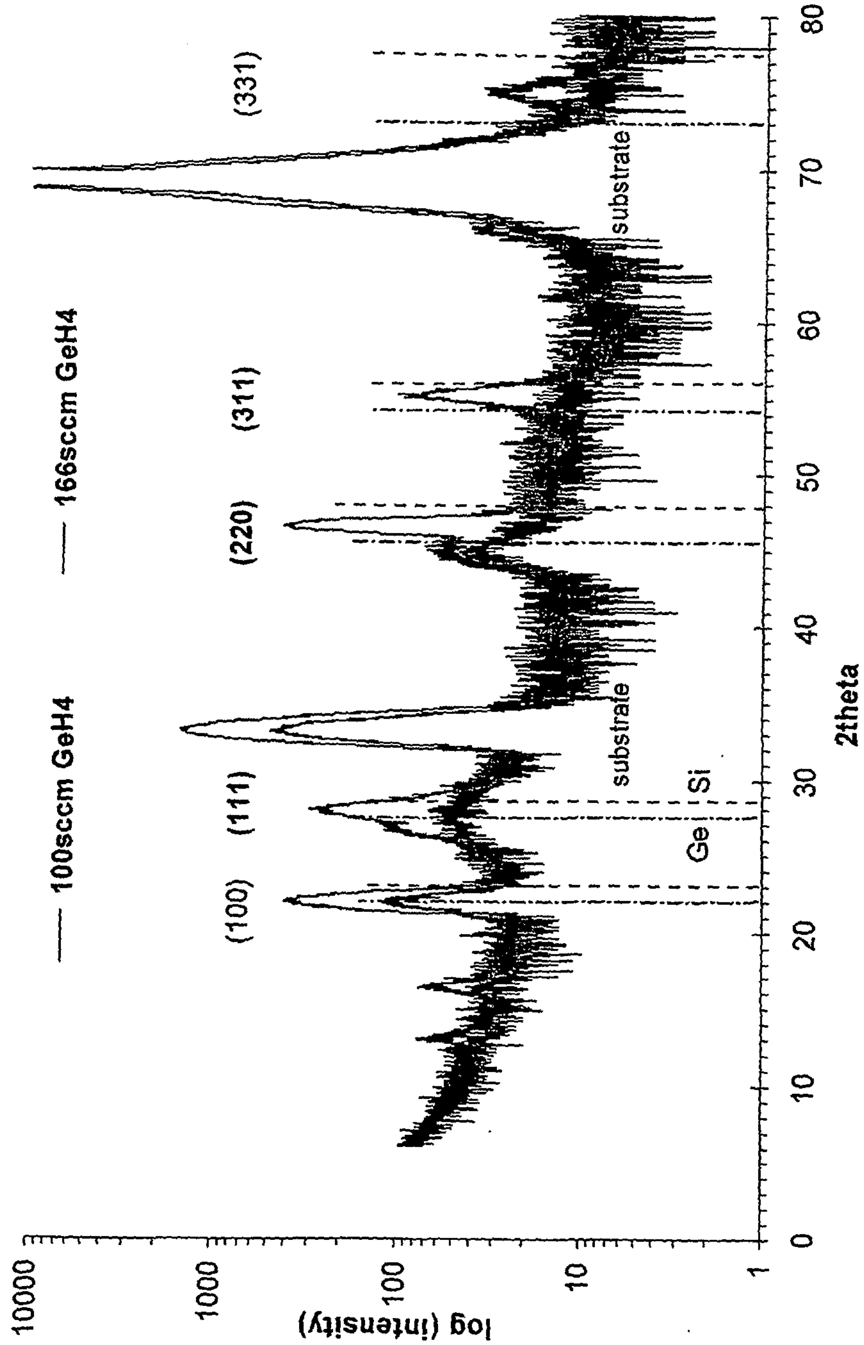
100sccm GeH4
166sccm GeH4
(100)
(111)
(220)
(311)
(331)
substrate
substrate
Ge
Si
log (intensity)
10000
1000
100
10
1
0
10
20
30
40
50
60
70
80
2theta

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6194722 B
- EP 0867702 A
- WO 0042231 A


### Non-patent literature cited in the description


- **A. Witvrouw.** Why CMOS-integrated transducers? A review. *Microsystem Technologies,* 2000, vol. 6 (5), 192-199
- **J. Singh ; S. Chandra.** Strain studies in LPCVD polysilicon for surface micromachined devices. *Sensors and Actuators A,* 1999, vol. A77 (2), 133-8
- **A.E. Franke.** Post CMOS Modular Integration of poly-SiGe microstructures using poly-Ge sacrificial layers. *Solid state sensors and actuator workshop,* 04 June 2000
- **TSU-JAE KING et al.** DEPOSITION AND PROPERTIES OF LOW-PRESSURE CHEMICAL-VAPOR DEPOSITED POLYCRYSTALLINE SILICON-GERMANIUM FILMS. *JOURNAL OF THE ELECTROCHEMICAL SOCIETY, ELECTROCHEMICAL SOCIETY,* 01 August 1994, vol. 141 (8), 2235-2241
- **FRANKE A E et al.** POST-CMOS INTEGRATION OF GERMANIUM MICROSTRUCTURES. *TECHNICAL DIGEST OF THE IEEE INTERNATIONAL MEMS '99 CONFERENCE. 12TH IEEE INTERNATIONAL CONFERENCE ON MICRO ELECTRO MECHANICAL SYSTEMS,* 17 January 1999, 630-637
- **UNEWISSE M H et al.** THE GROWTH AND PROPERTIES OF SEMICONDUCTOR BOLOMETERS FOR INFRARED DETECTION. *PROCEEDINGS OF THE SPIE,* 13 July 1995, vol. 2554, 43-54